(19) Europäisches Patentamt
European Patent Office
Office européen des brevets

(11) EP 3 387 388 B1

(12) **EUROPÄISCHE PATENTSCHRIFT**

(45) Veröffentlichungstag und Bekanntmachung des Hinweises auf die Patenterteilung:
**10.03.2021 Patentblatt 2021/10**

(21) Anmeldenummer: **16828920.5**

(22) Anmeldetag: **07.12.2016**

(51) Int Cl.:
***G01D 5/14*** *(2006.01)* ***G01P 3/487*** *(2006.01)*
***G01D 5/244*** *(2006.01)* ***G01R 33/09*** *(2006.01)*

(86) Internationale Anmeldenummer:
**PCT/DE2016/000434**

(87) Internationale Veröffentlichungsnummer:
**WO 2017/097285 (15.06.2017 Gazette 2017/24)**

# (54) MAGNETISCHER UMDREHUNGSZÄHLER UND VERFAHREN ZUR BESTIMMUNG VON MIT DIESEM UMDREHUNGSZÄHLER ERMITTELBAREN UMDREHUNGSZAHLEN

MAGNETIC REVOLUTION COUNTER AND METHOD FOR DETERMINING NUMBERS OF REVOLUTIONS THAT CAN BE DETERMINED BY MEANS OF SAID REVOLUTION COUNTER

COMPTE-TOURS MAGNÉTIQUE ET PROCÉDÉ DE DÉTERMINATION DU NOMBRE DE TOURS POUVANT ÊTRE DÉTECTÉ PAR CE COMPTE-TOURS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.12.2015 DE 102015016163**

(43) Veröffentlichungstag der Anmeldung:
**17.10.2018 Patentblatt 2018/42**

(73) Patentinhaber:
- **Leibniz-Institut für Photonische Technologien e.V.**
  **07745 Jena (DE)**
- **Horst Siedle GmbH & Co. KG.**
  **78120 Furtwangen (DE)**

(72) Erfinder:
- **MATTHEIS, Roland**
  **07743 Jena (DE)**
- **DIEGEL, Marco**
  **07743 Jena (DE)**

(74) Vertreter: **Pfeiffer, Rolf-Gerd**
**Patentanwaltsbüro**
**Pfeiffer & Kollegen**
**Engelplatz 11**
**07743 Jena (DE)**

(56) Entgegenhaltungen:
**WO-A1-2013/164361 DE-A1-102010 010 893**
**DE-A1-102011 075 306**

- **DIEGEL M ET AL: "A New Four Bit Magnetic Domain Wall Based Multiturn Counter", IEEE TRANSACTIONS ON MAGNETICS, IEEE SERVICE CENTER, NEW YORK, NY, US, Bd. 45, Nr. 10, 1. Oktober 2009 (2009-10-01), Seiten 3792-3795, XP011276998, ISSN: 0018-9464, DOI: 10.1109/TMAG.2009.2024426**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 3 387 388 B1

## Beschreibung

Die Erfindung betrifft einen magnetischen Umdrehungszähler und ein Verfahren zur Bestimmung von mit diesem Umdrehungszähler ermittelbaren Umdrehungszahlen eines äußeren Magnetfeldes, welche in vielfältigen Gebieten der Technik, insbesondere im Automobil- und Getriebebau vorteilhaft Anwendung finden können, da solche Umdrehungszähler miniaturisiert ausgebildet und stromlos betrieben werden können.

Grundsätzlich sind Umdrehungszähler zur berührungslosen und leistungslosen Zählung von Umdrehungen unter Nutzung von magnetischen Domänenwänden (DW) an sich bekannt und bspw. in DE 10 2008 063 226 A1, DE 10 2010 022 611 A1, DE 10 2011 075 306 A1, DE 10 2013 018 680 A1, DE 10 2010 010893 A1 und DE 10 2011 075306 A1 eingehend beschrieben.

Den in vorstehenden Schriften offenbarten Umdrehungszähler ist gemeinsam:
Die zum Einsatz gelangenden Sensorsysteme bestehen aus mindestens einem Sensorelement und mindestens einem äußeren Magnetfeld, wobei berührungsfrei entweder das Sensorelement am Magnetfeld, bzw. das Magnetfeld am Sensorelement vorbeibewegt oder gedreht wird.
Das Sensorelement weist zumindest partiell einen Schichtaufbau, bestehend aus mindestens einer hartmagnetischen und mindestens einer weichmagnetischen Schicht, getrennt von einer unmagnetischen Schicht, auf. Im Betrieb des Sensorsystems kann das Drehen oder Vorbeibewegen des Magnetfeldes am Sensorelement (oder umgekehrt) nur die Magnetisierung der weichmagnetischen Schicht und nicht die Magnetisierung der hartmagnetischen Schicht ändern. Hierdurch wird die Magnetisierung der weichmagnetischen Schicht im Sensorelement ganz oder teilweise eher parallel oder eher antiparallel zur Magnetisierung der hartmagnetischen Schicht orientiert sein. Diese unterschiedliche Ausrichtung der Magnetisierungen führt zu einem Unterschied des elektrischen Widerstands in unterschiedlichen Leitbahnabschnitten, der mittels GMR- oder TMR-Effekt auslesbar ist.
Innerhalb der weichmagnetischen Schicht sind zwei verschieden magnetisierte Bereiche durch eine magnetische Domänenwand (DW) voneinander getrennt.
Im Betrieb des Sensorsystems führt eine Lageveränderung des äußeren Magnetfelds, bspw. durch Rotation, im Sensorelement zur leistungslosen Bewegung der im Sensorelement existierenden magnetischen Domänenwände.
Die ausgelesenen DW-Positionen sind eineindeutig bestimmten, mit dem konkreten Umdrehungszähler ermittelbaren Umdrehungen (Umdrehungszahlen) zugeordnet und werden in einer Auswerteelektronik ermittelt. In bevorzugten Ausführungsformen sind mehrere Sensorelemente oder mehrere Teile eines Sensorelementes in Wheatstone-Brücken oder Wheatstone-Halbbrücken elektrisch miteinander verschaltet, wodurch der Einfluss der Temperatur auf das magnetoresistive Signal unterdrückt wird.

Die Umdrehungszähler nach der DE 10 2008 063 226 A1 sind geometrisch durch eine rautenförmige Spirale gebildet, die an einem Ende in einer großen Fläche endet. Diese große, bevorzugt kreisförmige Fläche fungiert als Domänenwandgenerator (DWG) und ist aus derselben Materialschichtkombination wie die Spirale gebildet. Nach jeder 180° Magnetfelddrehung oder 180° Sensorelementdrehung wird in diesem Domänenwandgenerator eine sogenannte 180°-Domänenwand am Übergang Fläche-Spirale erzeugt. Diese 180°-DW wandert in die Spirale hinein. Die erzeugten 180°-Domänenwände werden bei Drehrichtung des Magnetfeldes im Spiralendrehsinn zum Spiralenende transportiert, bzw. bei Drehrichtung entgegen des Spiralendrehsinns werden die DW zum DWG hin transportiert. Dabei annihiliert die aus der Spirale zuerst am DWG ankommende 180°-DW mit der zugleich im DWG erzeugten 180°-DW. Die Spirale kann durch sukzessives Drehen des Magnetfeldes somit schrittweise von Domänenwänden gelöscht werden. Äquivalent zur Drehung des Magnetfeldes am ortsfesten Sensorelement ist die Bewegung des Sensorelementes zum ortsfest montierten Magnetsystem.

Umdrehungszähler nach der DE 10 2011 075 306 A1 bestehen aus zwei rautenförmigen Spiralen mit je einem DWG an einem Ende mit entgegen gerichtetem Drehsinn, bzw. aus einer Kombination dieser zwei Spiralen mit nur einem DWG an einem Ende oder in der Mitte.

Gemeinsam ist diesen Umdrehungszählern nach der DE 10 2008 063 226 A1 und DE 10 2011 075 306 A1, dass sich bei jeder detektierten halben Umdrehung die Anzahl der 180°-Domänenwände in jeder Spirale um 1 ändert. Dies ist anders bei den Umdrehungszählern, die mindestens eine geschlossene Schleife mit mindestens einer Kreuzung (DE 10 2013 018 680 A1) oder mindestens eine geschlossene Schleife mit mindestens einer Brücke (DE 10 2010 022 611 A1) aufweisen. Bei diesen Umdrehungszählern wurden die beiden Enden einer Spirale zu einer geschlossenen Schleife miteinander verbunden. Bei n Windungen kreuzt die direkte Verbindung (n-1) Windungen. Eine zweiwindige Spirale wird somit zu einer Schleife mit einer Kreuzung und eine dreiwindige Spirale zu einer Schleife mit zwei Kreuzungen. Jede Windung kann maximal zwei Domänenwände aufnehmen, so dass bei einer Schleife mit n Windungen maximal 2n Domänenwände existieren können.

In einer geschlossenen Schleife wird im regulären Zähl-Betrieb keine DW erzeugt oder vernichtet. Eine Vernichtung oder Erzeugung von Domänenwänden würde zu einem Zählfehler führen und muss ausgeschlossen sein. Umdrehungszähler mit mindestens einer geschlossenen Schleife erfordern, dass in einem Initialisierungsprozess eine genaue Anzahl an Domänenwänden in das Sensorelement geschrieben wird.

Manche Ausführungsformen von Umdrehungszählern mit offenen Spiralen mit DWG können mechanisch initialisiert werden. Dies geschieht z.B. bei einer Spirale mit n Windungen durch Bewegung des Sensorelementes bzw. des äußeren Magneten des Sensorsystems um mindestens n Umdrehungen, um die Spirale komplett mit Domänenwänden zu füllen. Ein anschließendes Drehen in Gegenrichtung um n Umdrehungen leert die Spirale von Domänenwänden. Für Anwendungen, die Umdrehungen nach rechts und links zählen, wird für eine Initialisierung in Mittenposition die Spirale mit n Umdrehungen maximal mit Domänenwänden gefüllt und danach mit n/2 Umdrehungen mit entgegen gesetztem Drehsinn bis auf n/2 Domänenwände geleert. Bei den Umdrehungszählern mit geschlossener Schleife geschieht die Initialisierung z.B. durch komplettes Füllen der geschlossenen Schleife mit Domänenwänden mit Hilfe eines Magnetfeldpulses, dessen Stärke über der Nukleationsfeldstärke $H_{Nuk}$ der Schleife liegt, und anschließendes Löschen von Domänenwänden. Die Löschung von Domänenwänden erfolgt durch Annihilation von jeweils zwei Domänenwänden. Hierfür wird während einer Magnetfelddrehung eine DW unter einer Leiterbahn durch ein strominduziertes Feld, dem sogenannten Oersted-Feld $H_{Oerstedt}$, festgehalten (gepinnt) und eine weitere DW aufgrund der Felddrehung an die gepinnte DW heran transportiert, so dass die beiden Domänenwände annihilieren. Wenn z.B. die DW durch ein nach links zeigendes Magnetfeld zur Leiterbahn transportiert wird, so muss das strominduzierte Magnetfeld nach rechts zeigen, um der DW-Bewegung entgegengerichtet sein. Bei ausreichend großem Gegenfeld stoppt die DW-Bewegung an der Leiterbahn und die DW ist gepinnt. Wird das Oerstedtfeld für die nächsten mindestens 180° der Magnetfelddrehung aufrecht erhalten, so wird hierdurch eine zweite DW zur Leiterbahn transportiert. Diese zweite DW annihiliert mit der ersten, gepinnten DW. Durch sukzessives Weiterdrehen des einwirkenden Magnetfeldes und strominduziertes DW-Pinnen können so nacheinander immer zwei DW aus einer geschlossen Schleife gelöscht werden bis die gewünschte vorgebbare Zahl an Domänenwänden zum Betrieb des Sensorsystems erreicht ist.

Allen vorstehend beschriebenen Umdrehungszählern ist gemeinsam, dass das Zählen von Umdrehungen leistungslos durch das Transportieren von Domänenwänden in geschlossenen Schleifen, bzw. das Transportieren mit Erzeugung oder Vernichtung von Domänenwänden in offenen Spiralen erfolgt. Leistungslos erfolgt auch die Speicherung der gezählten Umdrehungen durch eineindeutige DW-Positionen und/oder DW-Anzahlen im Sensorelement. Leistung wird hingegen benötigt zum Auslesen des Sensorelementes. In bevorzugten Ausführungsformen wird hierzu der Giant Magneto Resistance- (GMR-) oder der Tunnel Magneto Resistance- (TMR-) Effekt genutzt, wobei mehrere Sensorelemente oder Teile eines Sensorelementes gemäß des bekannten Standes der Technik in Wheatstone-Halbbrücken oder Wheatstone-Brücken verschaltet sind. Je nach Magnetisierung weist ein Sensorelement in unterschiedlichen Abschnitten unterschiedliche elektrische Widerstände, bzw. unterschiedliche Potentiale auf, die, wenn das Sensorelement oder ein Teil eines Sensorelementes in Wheatstone-Halbbrücken oder Wheatstone-Brücken verschaltet ist, auslesbar sind. Zum Auslesen des Magnetisierungszustandes wird ein Messstrom durch das Sensorelement (bzw. die Wheatstone-(Halb-)Brücke) geleitet und das Messergebnis mit definierten Schwellenwerten verglichen. Je nachdem, ob ein Schwellenwert unterschritten oder überschritten ist, kann entschieden werden, ob das Messergebnis z.B. dem Zustand "eine DW ist in dieser Halbbrücke vorhanden" entspricht oder nicht.

In Umdrehungszählern nach der DE 10 2008 063 226 A1 wurde erstmals eine Rautenform mit Einzelkontaktierung von halben Windungen in Wheatstone-Halbbrücken eingeführt. Diese besonders vorteilhafte Ausgestaltung mit Quadratform verwendet pro Windung vier Stege im 90°-Winkel zueinander. Jeweils zwei Stege sind mit Viertelkreisen oder viertelkreisartigen Polygonzügen miteinander verbunden. Die Viertelkreise sind mit elektrischen Kontakten bedeckt, die zusätzlich Teile der angrenzenden Stege derart bedecken, dass die nicht kontaktierten Teile aller Stege zwischen den elektrischen Kontakten bevorzugt gleich lang sind. Die vier Stege jeder Windung sind verschaltet in zwei Wheatstone-Halbbrücken. Die Referenzrichtung liegt in der Diagonalen der Raute bzw. des Quadrats und senkrecht zur Linie zwischen dem Vcc-Kontakt und dem gnd-Kontakt. Hierdurch ist für jeden Feldwinkel immer eine eineindeutige Zuordnung zur gezählten Umdrehungszahl mit nur einer quadratischen (rautenförmigen) Spirale möglich. Dies erlaubt, wie in der Publikation "IEEE Transactions on Magnetics, Vol. 45, No 10, pp 3792 - 3795, 2009" dargestellt, eine eineindeutige Zuordnung der Magnetisierung mit der gezählten Umdrehung für alle mit dem Sensor zählbaren Umdrehungen.
Diese Geometrie ermöglicht Umdrehungszähler mit einer ermittelbaren Umdrehungszahl von n >10. Technisch realisiert ist im Sensorsystem "RSM 2800" der Firma Novotechnik eine quadratische Spirale zur Zählung von bis zu 16 Umdrehungen.

Allen diesen Umdrehungszählern gemeinsam ist, dass das Feld H des Magneten des Sensorsystems im Betrieb innerhalb eines "magnetischen Fensters" zwischen $H_{min}$ und $H_{max}$ liegen muss, wobei $H_{min}$ größer als das maximale Depinningfeld $H_{depinn}$ und $H_{max}$ kleiner als das Nukleationsfeld $H_{Nuk}$ des Sensorelementes sein muss:

$$H_{depinn} < H_{min} \leq H \leq H_{max} < H_{Nuk}$$

Das Maximalfeld $H_{max}$ und Minimalfeld $H_{min}$ wird von der Applikation vorgegeben. Allen diesen Umdrehungszählern ist weiterhin gemeinsam, dass die Sensorelemente beim Maximalfeld $H_{max}$ und beim Minimalfeld $H_{min}$ der Applikation geeignet getestet sind bezüglich einer gewissen Fehlerwahrscheinlichkeit von z.B. kleiner $10^{-7}$. Innerhalb dieses mag-

netischen Fensters werden die Domänenwände sicher transportiert. Um bei allen Feldwinkeln eine eineindeutige Zuordnung der Signale zur gezählten Umdrehungszahl zu gewährleisten, werden bei der rautenförmigen Spirale mit einem DWG nicht alle Wheatstone-Halbbrücken ausgelesen. Es reicht hier aus, von der Spitze der Spirale nacheinander alle Wheatstone-Halbbrücken auszulesen, bis die Windung erreicht ist, in der sich die erste in die Spirale transportierte DW lokalisiert ist. Dies wird erkannt anhand eines Pegelsprunges. Zwingend erforderlich ist es hier jedoch, dass die der ausgelesenen Wheatstone-Halbbrücken jeweils nachfolgende halbe Windung auslesen wird, d.h. es wird gemäß des Standes der Technik immer mit einer 180° Auflösung ausgelesen. Von Vorteil ist, dass dieses Sensorelement halbe Umdrehungen ausgeben kann. Nachteilig ist aber, dass dies die Kontaktierung aller Halbbrücken erfordert und damit eine große Chip-Fläche benötigt wird, deren Größe somit wesentlich bestimmt wird durch den Platzbedarf der Bondkontakte, von denen jeder für sich etwa einen Platzbedarf in der Größenordnung des eigentlichen Sensorelements erfordert.

Die geometrischen Bereiche, in denen die Domänenwände innerhalb der Spirale oder Schleife die meiste Zeit über lokalisiert sind, werden nachfolgend als Domänenwandlagen (DW-Lagen) bezeichnet. Bei quadrat- oder rautenförmigen Spiralen sind dies die Viertelkreise oder viertelkreisähnlichen Polygonzüge, die jeweils zwei gerade Stege miteinander verbinden. Damit eine DW einen Viertelkreis durchläuft, muss das äußere Magnetfeld um 90° plus einen Hysteresewinkel von typisch 5° bis 20° gedreht werden. Sobald die DW zum Übergang Viertelkreis-Steg transportiert wird und das anliegende Feld die DW depinnt, durchläuft die DW den Steg mit einer Geschwindigkeit von mehreren 100 m/sec in wenigen 100 ns. Innerhalb dieser sehr kurzen Zeit ist die Drehung des äußeren Magnetfeldes vernachlässigbar klein.

Pro Windung gibt es bei einer quadratischen Spirale (bzw. einer quadratischen Schleife) vier Viertelkreise und somit vier DW-Lagen, die mit den elektrischen Kontakten von zwei Wheatstone-Halbbrücken bedeckt sind. Über einer DW-Lage liegt der Vcc-Kontakt, über der gegenüberliegenden DW-Lage der gnd-Kontakt und die zwei dazwischen liegenden DW-Lagen sind jeweils mit einem Mittelkontakt bedeckt.

In allen vorstehend beschriebenen Umdrehungszählern nach dem bekannten Stand der Technik haben die mit einem Wheatstone-Halbbrücken-Mittenkontakt kontaktierten DW-Lagen einen Winkelabstand von 180°.

Durch die Wahl der Richtung der Referenzmagnetisierung im GMR-Schichtstapel ist die Wheatstone-Halbbrücke im Mittelpotential, wenn eine DW in der DW-Lage unter dem Mittelkontakt positioniert ist und sie ist im High-Potential oder im Low-Potential, wenn die DW in der DW-Lage unter dem Vcc- oder dem gnd-Kontakt positioniert ist. Für TMR-Schichtstapel kann dies variabler gewählt werden.

Für jede 180° Magnetfelddrehung werden die im Sensorelement gespeicherten Domänenwände im fehlerfreien Betrieb in die benachbarte Wheatstone-Halbbrücke transportiert. Bei den Umdrehungszählern mit konstanter DW-Anzahl verschiebt sich dabei die DW-Anordnung um den Winkelabstand von 180° im Sensorelement und bei der Spirale mit einem DWG ändert sich zusätzlich die Anzahl der Domänenwände in der Spirale um eine DW. Der Nachweis dieser Bewegung erfolgt über die elektrische Auslesung der Wheatstone-Brücken bzw. -Halbbrücken. Da die DW-Lagen zweier benachbarter Wheatstone-Halbbrücken unter dem jeweiligen Mittelkontakt einen Winkelabstand von 180° aufweisen, verwendet die Ausleseelektronik somit einen "180°-Auslesealgorithmus", der mit 180°-Auflösung die Umdrehungen analysiert, unabhängig davon, ob die Ausleseelektronik nur ganzzahlige Umdrehungszahlen oder auch halbzahlige Umdrehungszahlen ausgibt. Das Auslesen aller Wheatstone-Halbbrücken erfordert, dass alle Mittelkontakte an Bondkontakten angebunden sind. Dieses Kontaktierungsschema wird nachfolgend als "180°-Kontaktierung" bezeichnet.

Eine 180°-Kontaktierung verwenden auch die teilerfremden Sensorelemente nach DE 102010022611 A1 und DE 10 2013 018 680 A1.

Der entscheidende Nachteil dieser 180°-Kontaktierung ist die benötigte große Chipfläche pro Sensorelement, um die erforderlichen Bondkontakte unterzubringen, wobei insbesondere bei Umdrehungszählern für Umdrehungszahlen größer 10 die Bondkontaktanzahl die Chipfläche und damit die Kosten pro Chip maßgeblich bestimmt.

Die Bondkontakt-Anzahl ist durch eine multiplexte Spannungsversorgung reduzierbar. Bei einer Spirale mit einem Domänenwandgenerator (DWG) und 16 Windungen werden bei einer gemeinsamen Spannungsversorgung aller 16 Windungen insgesamt 34 Kontakte benötigt: Ein Vcc-Kontakt, ein gnd-Kontakt und 16 x 2 Mittelkontakte für 32 Wheatstone-Halbbrücken. Bei einem vierfach-Multiplexing werden dagegen insgesamt nur noch 16 Kontakte benötigt: Vier Paare von Vcc- und gnd-Kontakten und 4 x 2 Mittelkontakte, wobei jeder Kontakt jeweils vier Windungen kontaktiert. Durch rasches Hintereinanderbeschalten der vier Vcc-gnd-Paare werden an einem Mittelkontakt somit hintereinander die Potentiale der vier kontaktierten Windungen einzeln auslesbar. In Ausgestaltungen mit multiplexter Spannungsversorgung sind nicht alle Wheatstone-Halbbrücken auf dem gleichen Potential, so dass bei der Messung einer Wheatstone-Halbbrücke die parallel geschalteten Potentiale (hier von drei Windungen, respektive Wheatstone-Halbbrücken) das Messergebnis beeinflussen können. In der DE 10 2010 010 893 B4 wurden Umdrehungszähler mit elektrischen Schaltungen kombiniert, die mittels Referenzbrücken die Effekte, die durch parallel geschalteten Potentiale entstehen, kompensieren. Die vorteilhafte Beschaltung mit Referenzbrücken erfordert einen zusätzlichen 17. Kontakt bei einer Spirale mit einem DWG und 16 Windungen.

Aufgabe vorliegender Erfindung ist es, einen magnetischen Umdrehungszähler und ein Verfahren zur Bestimmung von mit diesem Umdrehungszähler ermittelbaren Umdrehungszahlen anzugeben, die eine weitergehend verringerte Anzahl von Bondkontakten ermöglichen und der Umdrehungszähler somit auf kleineren Chipflächen und damit kostengünstiger herstellbar ist.

Die Aufgabe wird gelöst durch die kennzeichnenden Merkmale von Anspruch 1, 2 und 8. Vorteilhafte Ausgestaltungen der Erfindung sind Gegenstand der jeweils nachgeordneten Ansprüche.

Das Wesen der Erfindung besteht darin, dass zunächst ein magnetischer Umdrehungszähler zur Bestimmung einer vorgebbaren Anzahl zu bestimmender Umdrehungen eines äußeren Magnetfelds, erzeugt durch ein rotierendes Element, respektive ein Polrad, respektive einen linearen magnetischen Maßstab vorgesehen ist,

- der magnetische Domänenwandleitbahnen beinhaltet, die aus offenen Spiralen oder in sich geschlossenen mehrfach verwundenen Schleifen bestehen, die durch einen GMR-Schichtstapel oder einer weichmagnetischen Schicht mit lokal vorhandenen TMR-Schichtstapeln gebildet sind und
- in die magnetische 180°-Domänenwände einbringbar und -durch Messung des elektrischen Widerstands vorgebbarer Spiralen- oder Schleifenabschnitte- entsprechend des bekannten Standes der Technik lokalisierbar sind,
- wobei erfindungsgemäß hier jedoch in die Domänenwandleitbahnen eine einzige Domänenwand oder mindestens zwei magnetische Domänenwände derart eingebracht sind, dass sie durch Mittel zum Erzeugen, Pinnen oder definierten Löschen von Domänenwänden in einen definierten Abstand von größer als 360° zueinander -bezogen auf ihre Ortsveränderung von erster zu zweiter Position, bei Drehung des rotierenden Magnetfeldes um den Winkel von größer als 360°- gebracht und dauerhaft so zueinander beabstandet sind und
- auf den Domänenwandleitbahnen elektrische Kontakte derart vorgesehen sind, dass die Domänenwandleitbahnen diagonal gegenüber liegend von je einem Vcc- und einem gnd-Kontakt gemeinsam oder in Gruppen von mehreren Vcc- und gnd-Kontakten für Multiplex-Auslesung erfasst sind und
- ausschließlich einseitig, bezogen auf die über dem Vcc- und gnd-Kontakt liegende Diagonale, elektrische Kontakte vorgesehen sind, die
- im Wesentlichen mittig zwischen genanntem Vcc- und gnd-Kontakt(en) jeweils eine Windung oder bei Multiplex-Auslesung mehrere Windungen kontaktieren auf jedem dazwischen liegenden Domänenwandleitbahnabschnitt und
- genannte Kontakte zu separaten, vorzugsweise parallel auslesbaren oder bei Multiplex-Auslesung zu rasch hintereinander, quasi gleichzeitig auslesbaren Wheatstonehalbbrücken verschaltet sind,
- wobei die von den Wheatstonehalbbrücken ermittelten Widerstandsverhältnisse als Signalpegel sämtlich in einem Speicher tabellenartig abgelegt sind, der zur Ermittlung der aktuellen Umdrehungszahl fortlaufend mit in einem weiteren Speicher abgelegten, der konkreten Umdrehungszahl entsprechenden, tabellenartigen Sollwertmuster verglichen wird.

Alternativ zur Auslesung des Sensorelementes mit Potentialmessungen durch eine Verschaltung in Wheatstonehalbbrücken sieht die Erfindung auch vor, das Sensorelement durch Messung der (TMR)-Widerstände aller Windungen auszulesen. Hierzu wird entweder jede einzelne Windung mit je einem gnd-Kontakt und je einem Vcc-Kontakt kontaktiert oder in bevorzugten Ausführungsformen mit Multiplex-Auslesung mit einem gemeinsamen gnd-Kontakt und je einem Vcc-Kontakt auf je einer Windung, bzw. mit einem gemeinsamen Vcc-Kontakt und je einem gnd-Kontakt auf je einer Windung, kontaktiert. Die gnd- und Vcc-Kontakte sind bevorzugt diagonal gegenüber liegend angeordnet. Figur 14 zeigt eine Ausführungsform für diese Verschaltung. Die ermittelten Widerstände werden hier, wie bei der Verschaltung mit Wheatstonehalbbrücken, als Signalpegel sämtlich in einem Speicher tabellenartig abgelegt, der zur Ermittlung der aktuellen Umdrehungszahl fortlaufend mit in einem weiteren Speicher abgelegten, der konkreten Umdrehungszahl entsprechenden, tabellenartigen Sollwertmuster verglichen wird.

Bevorzugte Ausführungsformen beinhalten, entsprechend des Standes der Technik, einen Drehwinkelsensor (respektive einen Quadrantensensor), um durch Vorauswahl eines Feldwinkelquadranten die Messwerte nur mit denjenigen Sollwertmustern zu vergleichen, die mit dem gemessenen Feldwinkelquadranten verknüpft sind. Dies reduziert die Anzahl der maximal erforderlichen Vergleiche auf ein Viertel und beschleunigt somit die Umdrehungszahl-Bestimmung.

Die Anzahl der maximal erforderlichen Vergleiche zur Umdrehungszahl-Bestimmung wird weiterhin dadurch gering gehalten, dass im regulären Zählbetrieb die DW-Anzahl konstant bleibt, wodurch pro Umdrehung und Feldwinkelquadranten nur genau je ein mögliches Signalmuster existiert und somit auch nur je ein Sollwertmuster zum Vergleich abgespeichert sein muss.

Gemäß vorliegender Erfindung sind dabei die, die Domänenwandleitbahnen bildenden offenen Spiralen oder in sich geschlossenen, mehrfach verwundenen Schleifen im Wesentlichen rhombusförmig ausgebildet, wobei die genannten Kontakte die Eckbereiche der Rhomben erfassen. Weiterhin ist die definierte Beabstandung bei Einsatz zweier benachbarter Domänenwände bevorzugt zu 540° festgelegt.

Anstelle der Verwendung von GMR-Schichtstapeln ist es auch erfindungsgemäß möglich, die Domänenwandleitbahnen aus einem weichmagnetischen Material - z.B. Permalloy - herzustellen und die Vcc- und gnd-Kontakte auf TMR-Schichtstapel zu platzieren, die auf den Domänenwandleitbahnen, z.B. in der Mitte, vorgesehen sind. Die elektrischen Mittelkontakte dagegen kontaktieren die weichmagnetische Domänenwandleitbahn auch hier direkt in den Eckbereichen der Rhomben.

Das Wesen des zum Einsatz gelangenden Verfahrens zur Bestimmung der Umdrehungszahlen besteht darin, dass die Bestimmung der gezählten Umdrehung mit einer Auswerteelektronik erfolgt, die einen Vergleich der Signale aller ausgelesenen Wheatstone-Halbbrücken (oder der Widerstände aller Windungen bei Widerstandsmessung) durchführt mit einer abgespeicherten Tabelle, die für jede zählbare Umdrehung die jeweiligen Signale der Wheatstone-Halbbrücken (bzw. der Widerstände aller Windungen) hinterlegt hat. Das heißt, die Auswerteelektronik gibt als gezählte Umdrehung diejenige aus, bei der das Muster aus den gemessenen Signalspannungen von Windung 1 bis Windung n der offenen Spiralen oder in sich geschlossenen mehrfach verwundenen Schleifen mit einem abgespeicherten Signalmuster für Windung 1 bis Windung n übereinstimmt. Aufgrund der 90°-Winkel in den bevorzugten Ausführungsformen mit einer quadratischen Spirale oder in sich geschlossenen quadratischen Schleife ändert sich das Potential nach jeweils 90° Felddrehung, so dass zumindest für jeden 90°-Feldwinkelbereich (Feldwinkel-Quadranten) ein entsprechendes Sollwertmuster abgespeichert ist, das mit dem Messwert vom Winkelsensor (respektive Quadrantensensor) zum Vergleich mit dem Umdrehungszähler-Signalen ausgewählt wird.

Die in die Schleifen oder Spiralen eingeprägten Magnetisierungsmuster ermöglichen somit eine eineindeutige Bestimmung der gezählten Umdrehungen selbst bei einer zulässigen Hysterese von $\pm 45°$. Aus Gründen der Betriebssicherheit wird man immer Feldstärken (z.B. 120% von $H_{min}$) wählen, bei der die reale Hysterese immer deutlich kleiner als $\pm 30°$ ist.

Die erfindungsgemäße Anordnung der elektrischen Mittelkontakte auf einer Seite der rhombenförmigen Sensorelemente, bzw. auf einer Seite bezogen auf die den Vcc-Kontakt und gnd-Kontakt verbindenden Diagonale, wird nachfolgend als 360°-Kontaktierung bezeichnet, da die mit dem Sensorelement gezählte und im Sensorelement gespeicherte Umdrehungszahl mit 360°-Auflösung ausgelesen wird. In den spiral- oder schleifenförmigen Sensorelementen können erfindungsgemäß die gleichen Magnetisierungsmuster (MM) initialisiert werden. Das bevorzugte MM für die 360°-Kontaktierung weist dabei zwei Domänenwände mit einem Winkelabstand zueinander von 540° auf, welches eine eineindeutige Bestimmung der gezählten Umdrehungszahl ermöglicht und welches sich leicht initialisieren lässt, wie in der nachfolgenden speziellen Beschreibung näher ausgeführt wird. Ein weiteres erfindungsgemäßes MM besteht aus nur einer einzigen DW, welche in ebenfalls erfindungsgemäße Spiralen mit zwei angespitzten offenen Enden eingeschrieben wird, wobei diese Spirale ebenfalls mit o.g. 360°-Kontaktierung versehen ist, wie in der nachfolgenden speziellen Beschreibung zu dieser Ausführungsform detaillierter beschrieben wird.

Zur näheren Erläuterung des Vorstehenden und der Erfindung sollen nachstehende vorteilhafte, die Erfindung aber nicht beschränkende Ausführungsbeispiele und Figuren dienen. Es zeigen:

Fig. 1 die wesentlichen Bestandteile eines Umdrehungszählers nach vorliegender Erfindung;

Fig. 2 ein erstes prinzipielles Beispiel für die Ausgestaltung des erforderlichen Sensorelements mit der erfindungsgemäßen Kontaktanordnung;

Fig. 3a anhand von Fig. 2 das Einschreiben eines erfindungsgemäß bevorzugt vorgesehenen Magnetisierungsmusters;

Fig. 3b anhand von Fig. 2 das Einschreiben eines erfindungsgemäß ebenfalls möglichen Magnetisierungsmusters, bestehend aus nur einer Domänenwand;

Fig. 4 ein zweites prinzipielles Beispiel für die Ausgestaltung des erforderlichen Sensorelements mit einer erfindungsgemäßen Kontaktanordnung;

Fig. 5 ein Beispiel für die erzielte Bondkontakteinsparung anhand von Fig. 4 in einer vollständigeren Chipansicht des Umdrehungssensors;

Fig. 6 die Verschaltung der erfindungsgemäß vorgesehenen und auf dem Umdrehungssensor angeordneten Kontakte zur Bildung von Wheatstonebrücken nach dem Beispiel von Fig. 4;

Fig. 7 ein drittes prinzipielles Beispiel für die Ausgestaltung des erforderlichen Sensorelements mit der erfindungsgemäßen Kontaktanordnung und einer Ausgangsdomänenwandlage;

Fig. 8 die Domänenwandlage nach Fig. 7 nach drei Umdrehungen des äußeren Magnetfeldes;

Fig. 9 Signalpegelfolgen, erhalten von den vorgesehenen 360°-Wheatstone-Kontakten für vier beispielhafte Quadranten nach den Fig. 7 und 8;

Fig. 10 ein Flussdiagramm für den Ablauf der Bestimmung einer Umdrehung korreliert mit den zugehörigen Baugruppen;

Fig. 11 einen Umdrehungszähler nach Figur 1 kombiniert mit einem Polrad;

Fig. 12 einen Umdrehungszähler nach Figur 1 kombiniert mit einem Linear-Maßstab und

Fig. 13a und 13b beispielhaft eine Ausführung gemäß Fig. 4, hier mit TMR-Kontakten und der erfindungsgemäßen 360°-Kontaktierung und

Fig. 14 das Sensorelement von Fig 13a mit einer erfindungsgemäßen Kontaktanordnung zur Widerstandsmessung.

Nachfolgend werden anhand beiliegender Figuren erfindungsgemäße Ausgestaltungen von Umdrehungszählern mit der erfindungsgemäßen 360°-Kontaktierung beschrieben, die bei jedem Feldwinkel eine eineindeutige Auslesung von ganzen Umdrehungszahlen ermöglichen.

Zunächst zeigt Fig. 1 die wesentlichen Bestandteile eines solchen Umdrehungszähler-Systems 1 mit einem erfindungsgemäßen Umdrehungszähler 1a und einem Magnetsystem 4 mit Nordpol (N) und Südpol (S) montiert an einer drehenden Welle 5. Der Umdrehungszähler 1a besteht aus den Hauptkomponenten: Umdrehungssensor US 2, 360°-Winkelsensor WS 3, und einer Elektronik 6. Die Sensoren 2 und 3 sind ortsfest montiert und detektieren die Winkellage und die Anzahl der Umdrehungen des rotierenden Magnetfeldes. Die Elektronik 6 beinhaltet Spannungsversorgungen 7 für die Sensoren 2 und 3 und die Verarbeitung der Messwerte, einen Speicher 8 für die Messwerte des Winkelsensors 3 und einen Speicher 9 für die Messwerte des Umdrehungssensors 2, einen Speicher 10 für tabellenartig abgespeicherte Sollwerte des Umdrehungssensors 2 und eine Verarbeitungseinheit 11, die die Messwerte aus den Speichern 8 und 9 mit den Tabellenwerten des Speichers 10 vergleicht und das Ergebnis jeder Messung ausgibt.

Die erste Besonderheit vorliegender Erfindung besteht in der erfindungsgemäßen Ausbildung des Umdrehungssensors 2, der anhand einer beispielhaften und vereinfachten Darstellung in Fig. 2 erläutert werden soll. Hier soll insbesondere die erfindungsgemäße Ausgestaltung bzgl. der neuen Art der Kontaktanbindung dargestellt werden.
In diesem Beispiel ist das Sensorelement 2 durch eine dreiwindige, quadratische Spirale 20, deren Enden angespitzt sind, gebildet. Die eine Spitze 21 ist das Ende der äußeren Windung und die andere Spitze 22 das Ende der innersten Windung. Die Spirale besteht im Beispiel, entsprechend des bekannten Standes der Technik, aus einem magnetischen Schichtstapel, der den GMR-Effekt zeigt. Die Referenzrichtung 28 liegt diagonal zu den quadratischen Windungen. Die erste, äußerste Windung besteht aus den Stegen 31, 32, 33 und 34, die zweite, mittlere Windung aus den Stegen 41, 42, 43 und 44 und die dritte, innerste Windung aus den Stegen 51, 52, 53 und 54. Jeder der genannten Stege steht im Winkel von 90° zum jeweils benachbarten, sich anschließenden Steg. Nur zur Verdeutlichung der realen Verhältnisse ist gezeigt, dass die Verbindung zwischen den Stegen Viertelkreise oder viertelkreisähnliche Polygonzüge 302 sind (gezeigt im gezoomten Kreis 301), die aus demselben Schichtstapel wie die Stege bestehen. Diese Polygonzüge sind die "Ecken" der quadratischen Spirale und bilden zugleich die o.g. Domänenwand-Lagen (DW-Lagen). In DW-Lagen verharren Domänenwände für große Feldwinkelbereiche des äußeren sich drehenden Magnetfeldes, nach Fig. 1 erzeugt durch das Magnetsystem 4. Um eine DW durch einen Viertelkreis zu transportieren, muss sich das äußere Magnetfeld um 90° plus einem Hysteresewinkel von typisch 5° bis 20° drehen. Beim Transport durch einen Steg dreht sich das Magnetfeld praktisch kaum, da die DW die Stege mit mehreren 100 m/sec durchläuft. Demzufolge gelangt die DW innerhalb weniger 100 ns von einem Viertelkreis zum nächsten Viertelkreis. Zeitlich betrachtet verharren die Domänenwände somit praktisch die gesamte Zeit in den DW-Lagen. Die erste, äußerste Windung beinhaltet somit die DW-Lagen 35, 36, 37 und 38, die zweite Windung die DW-Lagen 45, 46, 47 und 48 und die dritte Windung die DW-Lagen 55, 56, 57 und 58.
Die beispielhafte Spirale ist mit elektrischen Kontakten versehen, und zwar einem gemeinsamen gnd-Kontakt 70 links oben, einen gemeinsamen Vcc-Kontakt 80 rechts unten und erfindungsgemäß ausschließlich drei Mittelkontakten 91, 93 und 95 in Fig. 2 rechts oben. Also anspruchsgemäß auf einer Spiralenhälfte, die mit einer gedachten Diagonale gebildet wird, die durch den Vcc- und gnd-Kontakt verläuft. Weiterhin zeigt Fig. 2 eine Leiterbahn 25 mit einer Verengung 26 zum Initialisieren des Sensorelementes. Der Magnetisierungszustand des Sensorelementes 2 wird durch Potentialmessung und Verschaltung zu drei Wheatstone-Halbbrücken ausgelesen:

Die Wheatstone-Halbbrücke W1 bilden die Stege 33 und 34 mit dem Mittelkontakt 91, dem gnd-Kontakt 70 und dem Vcc-Kontakt 80;
Die Wheatstone-Halbbrücke W2 bilden die Stege 43 und 44 mit dem Mittelkontakt 93, dem gnd-Kontakt 70 und dem Vcc-Kontakt 80;
Die Wheatstone-Halbbrücke W3 bilden die Stege 53 und 54 mit dem Mittelkontakt 95, dem gnd-Kontakt 70 und dem Vcc-Kontakt 80.

Das Sensorelement 2 nach Fig. 2 soll zunächst komplett gefüllt sein mit sechs Domänenwänden (schwarze Kreise), die z.B. nach einem Feldpuls mit einer Feldstärke über der Nukleationsfeldstärke des Sensorelementes 2 in Richtung der Magnetisierung der Referenzrichtung 28 erzeugt wurden:

In der ersten, äußersten Windung ist die DW 111 in der DW-Lage 36 und die DW 112 in der DW-Lage 38 lokalisiert,
In der zweiten, mittleren Windung ist die DW 113 in der DW-Lage 46 und die DW 114 in der DW-Lage 48 lokalisiert,
In der dritten, innersten Windung ist die DW 115 in der DW-Lage 56 und die DW 116 in der DW-Lage 58 lokalisiert.

Die genannten drei Halbbrücken befinden sich durch diese DW-Positionen und der Lage der Referenzrichtung 28 im Mittelpotential. Die Magnetisierungsrichtung in cw-Richtung ist dunkelgrau und die Magnetisierungsrichtung in ccw-Richtung ist hellgrau dargestellt. Zusätzlich ist in jedem Steg die Magnetisierungsrichtung mit einem Pfeil gekennzeichnet.

Die Referenzrichtung 28 des GMR-Schichtstapels ist diagonal zur quadratischen Spirale und zeigt im Beispiel von links unten nach rechts oben.
Um die vorliegender Erfindung zugrundeliegende Maßgabe der definierten Beabstandung zweier benachbarter Domänenwände von >360° zu realisieren, müssen noch mindestens zwei DW gelöscht werden. Dies wird nachstehend anhand von Figur 3 beschrieben.
Aus Gründen der Übersichtlichkeit weist die in Figur 2 gezeigte Spirale nur drei Windungen auf. Reale Sensorelemente weisen typischerweise zehn bis dreißig solcher Windungen auf, wenn diese Spiralenbauform gewählt wird.
Mit Bezug auf Fig. 2 zeigt Figur 3a das Sensorelement 2, bei dem ein Magnetisierungsmuster mit 540° Winkelabstand zwischen zwei benachbarten Domänenwänden initialisiert wurde, was eine 360°-Kontaktierung gemäß Fig. 2 für eine eineindeutige Umdrehungszählung ermöglicht. Während die vollständige Besetzung der Spirale mit Domänenwänden nicht für eine eineindeutige Umdrehungszählung bei der vorgesehenen Kontaktierung geeignet ist, soll anhand von Fig. 3a eine Möglichkeit zur Initialisierung eines erfindungsgemäß erforderlichen Magnetisierungsmusters einmal etwas ausführlicher beschrieben werden, die in sechs Schritten erfolgt:

1. Vor Einbau des Sensorsystems zur Zählung von n Umdrehungen (im Beispiel hier von drei Umdrehungen) wird ein hier nicht dargestellter mechanischer Endanschlag entriegelt und das äußere Magnetfeld n+1 Umdrehungen (hier vier) in ccw-Richtung gedreht, wodurch alle eventuell vorhandenen Domänenwände, respektive die in Fig. 2 dargestellten sechs Domänenwände, die Spirale über die Spitze 21 verlassen. Anschließend wird das Sensorelement in die gewünschte Nullstellung gedreht (hier die Mittenposition für die Zählung von n/2 Umdrehungen in cw- und n/2 Umdrehungen in ccw-Richtung) und der Endanschlag verriegelt;
2. Es folgt die Nukleation von zwei Domänenwänden durch Stromfluss über eine Leiterbahn 25 in der Windung unter der Verengung 26. Das strominduzierte Oerstedtfeld liegt über der Nukleationsfeldstärke des Sensorelementes 2. Die nukleierten zwei Domänenwände werden durch das in Referenzrichtung 28 zeigende Magnetfeld des Magneten 4 (entsprechend Fig. 1) in die DW-Lage 46 und in die DW-Lage 48 transportiert;
3. Bei abgeschaltetem Stromfluss durch die Leiterbahn 25 wird das äußere Magnetfeld um 360° in ccw gedreht, wodurch die zwei nukleierten DW aus DW-Lage 46 in die DW-Lage 36 und aus der DW-Lage 48 in die DW-Lage 38 transportiert werden;
4. Es folgt erneut die Nukleation von zwei Domänenwänden durch Stromfluss über die Leiterbahn 25 in der Windung unter der Verengung 26. Das strominduzierte Oerstedtfeld liegt über der Nukleationsfeldstärke des Sensorelementes 2. Eine DW wird in die DW-Lage 46 und die andere DW wird in die DW-Lage 48 transportiert durch das in Referenzrichtung 28 zeigende Magnetfeld des Magneten 4 (entsprechend Fig. 1);
5. Der Stromfluss durch die Leiterbahn 25 wird so weit reduziert, bis unter der Verengung 26 das resultierende Magnetfeld vom Sensorsystem und vom Oerstedtfeld (parallel zum Steg 42 anliegt und zur DW-Lage 46 zeigt) unterhalb der minimalen Bewegungsfeldstärke des Sensorelementes liegt. Durch eine 270°-cw-Drehung wird die DW aus der DW-Lage 46 und die DW aus den DW-Lage 38 bis zur Verengung 26 transportiert, wo sie annihilieren. Zugleich wird die DW aus der DW-Lage 36 in die DW-Lage 45 und die DW aus der DW-Lage 48 in die DW-Lage 57 transportiert;
6. Nach Ausschalten des Oerstedtfeldes erfolgt eine 90°-ccw-Drehung, wodurch die DW aus der DW-Lage 45 in die DW-Lage 38 und die DW aus der DW-Lage 57 in die DW-Lage 56 transportiert werden. Diese Domänenwände sind in Figur 3 als DW 111 (in der DW-Lage 38) und als DW 112 (in der DW-Lage 56) bezeichnet. Mit einem Kreuz gekennzeichnet sind die entstandenen DW-Lücken DWL 221 und DWL 222.

Wie im Rahmen der Erfindung gefordert, haben die in diesem Beispiel vorgesehenen zwei Domänenwände 111 und 112 einen Abstand zueinander von 540°, bezogen auf eine cw-Drehung des äußeren Magnetfeldes.
In weiterer Ausgestaltung der Erfindung zeigt Figur 3b das Sensorelement gemäß Fig. 2, das ein Magnetisierungsmuster mit nur einer einzigen Domänenwand aufweist. Die in Fig. 3b gezeigte Domänenwandleitbahn der Spirale 20 ist identisch mit der in Fig. 3a dargestellten Domänenwandleitbahn. Die in Fig. 3b gezeigte 360°-Kontaktierung mit gnd-Kontakt 70, Vcc-Kontakt 80 und den Mittelkontakten 91, 93 und 95 ist identisch zur 360°-Kontaktierung gemäß der Fig. 2 dargestellten. Im Gegensatz zu den Ausführungen nach den Figuren 2 und 3a wird in dem Beispiel nach Fig. 3b die Leiterbahn 25 mit der Verengung 26 zur Initialisierung des Magnetisierungsmuster MM mit einer einzigen DW nicht benötigt. Die Initialisierung erfolgt in diesem Beispiel z.B. in vier Schritten:

1. Vor Einbau des Sensorsystems zur Zählung von n Umdrehungen (im Beispiel hier von drei Umdrehungen) wird das Sensorelement einem Magnetfeld ausgesetzt, das oberhalb der Nukleationsfeldstärke liegt und z.B. in Richtung der Referenzmagnetisierung 28 zeigt. Hierdurch nukleieren in jeder Windung zwei DW, die die DW-Lagen einnehmen, die auf der Diagonalen von links unten nach rechts oben liegen. Diese (hier sechs) DW-Positionen sind bereits in Fig. 2 gezeigt;
2. Anschließend wird der hier nicht dargestellte mechanische Endanschlag entriegelt und das äußere Magnetfeld (vom in Fig. 1 gezeigten Magneten 4) um 270° in cw gedreht. Hierdurch verlässt die in Fig. 2 gezeigte und in der DW-Lage 58 positionierte DW 116 die Spirale über die Spitze 22. Zugleich wird die in Fig. 2 gezeigte DW 115 aus der DW-Lage 56 in die DW-Lage 65 transportiert, so dass sie vor dem letzten geraden Segment mit der Spitze 22 positioniert ist;

3. Durch drei ccw-Drehungen wird die DW aus der DW-Lage 65 in die DW-Lage 35 positioniert, wobei während dieses Transportes alle vor dieser DW positionierten Domänenwände die Spirale sukzessive über die Spitze 21 verlassen. Wenn die DW in der DW-Lage 35 positioniert ist, ist sie die einzige verbliebene DW in der Spirale. Diese DW wird in Fig. 3b als DW 111a bezeichnet.

4. Diese DW 111a wird anschließend in die Nullposition des Sensorelementes transportiert. Wenn die Nullposition die DW-Lage 35 ist (zur Zählung von drei cw-Umdrehungen), dann wird die Initialisierung mit der Verriegelung des Endanschlages abgeschlossen. Wenn die Nullposition die DW-Lage 47 zur Zählung von 1,5 Umdrehungen in cw- und 1,5 Umdrehungen in ccw-Richtung ist, dann wird die DW 111a mit 1,5 cw-Umdrehungen aus der DW-Lage 35 in die DW-Lage 47 transportiert und der Endanschlag verriegelt. Zur Zählung von drei ccw-Umdrehungen wird die DW 111a mit drei cw-Umdrehungen aus der DW-Lage 35 in die DW-Lage 65 transportiert.

Vorteil der Ausgestaltung nach Fig.3b ist der Verzicht auf die Leiterbahn 25 und somit der zugehörigen zwei Bondkontakte. Nachteilig ist jedoch die rein mechanische Initialisierung, die mit einer hohen Winkelpräzision erfolgen muss. Durch eine Fehlpositionierung beim DW-Nukleieren und/oder beim Leerdrehen der Spirale ist es leicht möglich, dass entweder alle DW die Spirale verlassen, so dass keine Umdrehungszählung möglich ist oder dass statt einer DW zwei Domänenwände mit einem Winkelabstand von 180° zueinander in der Spirale verbleiben, so dass keine eineindeutige Umdrehungszählung möglich ist. Grundsätzlich ist eine Ausgestaltung nach Fig. 3b aber möglich, ebenso bei höheren vorgesehenen Windungszahlen als der im Beispiel aufgeführten. Die im Rahmen der Erfindung vorzusehenden Mittel zum Erzeugen oder definierten Löschen von Domänenwänden sind in dieser Ausführungsform durch ein äußeres Magnetfeld, das bei der DW-Erzeugung eine Feldstärke oberhalb der Nukleationsfeldstärke aufweist und die mechanischen Mittel zum Austreiben unerwünschter Domänenwände aus der beidseits offenen Spirale gebildet.

Zur Demonstration der Multivalenz der im Rahmen der Erfindung zum Einsatz gelangenden Ausbildungen des Umdrehungssensors 2 bzgl. zum Einsatz gelangender Domänenwandleitbahnen soll ein zweites prinzipielles Ausführungsbeispiel nach Figur 4 dienen.

Fig. 4 zeigt eine weitere prinzipielle erfindungsgemäße Ausgestaltung eines Umdrehungssensors 2, hier bestehend aus einer vierwindigen, geschlossenen Schleife 27. Initialisiert wurde mit der Leiterbahn 25 mit der Verengung 26 ein Magnetisierungsmuster mit den zwei Domänenwänden DW 111 und DW 112 mit einem Winkelabstand von 540°. Die Referenzrichtung 28 des die Schleife 27 bildenden GMR-Schichtstapels ist diagonal zur quadratischen Spirale und zeigt von links unten nach rechts oben. Elektrisch kontaktiert wird diese Schleife analog zur Spirale in Figur 2 mit einem gemeinsamen gnd-Kontakt 70, einem gemeinsamen Vcc-Kontakt 80 und vier Mittelkontakten 91, 93, 95 und 97, die in einer Hälfte rechts oberhalb der Diagonale zwischen Vcc-Kontakt und gnd-Kontakt lokalisiert sind.

Der Magnetisierungszustand des Sensorelementes wird auch hier durch Potentialmessung mit vier Wheatstone-Halbbrücken ausgelesen:

Die Wheatstone-Halbbrücke WHB1 bilden die Stege 33 und 34 mit dem Mittelkontakt 91, dem gnd-Kontakt 70 und dem Vcc-Kontakt 80;

Die Wheatstone-Halbbrücke WHB2 bilden die Stege 43 und 44 mit dem Mittelkontakt 93, dem gnd-Kontakt 70 und dem Vcc-Kontakt 80;

Die Wheatstone-Halbbrücke WHB3 bilden die Stege 53 und 54 mit dem Mittelkontakt 95, dem gnd-Kontakt 70 und dem Vcc-Kontakt 80;

Die Wheatstone-Halbbrücke WHB4 bilden die Stege 63 und 64 mit dem Mittelkontakt 97, dem gnd-Kontakt 70 und dem Vcc-Kontakt 80.

Jede Windung ist mit einer Wheatstone-Halbbrücke beschaltet.

Auch in diesem Beispiel beträgt der Abstand zwischen den zwei benachbarten Domänenwänden DW 111 und DW 112 540° in cw-Richtung betrachtet.

Figur 5 zeigt ein Beispiel für die erzielte und aufgabengemäß angestrebte Bondkontakteinsparung anhand von Fig. 4 in einer vollständigeren Chipansicht des Umdrehungssensors. Figur 5 zeigt den Umdrehungssensor 2 aus Figur 4 auf einem Chip 202 mit Bondkontakten. Die Referenzrichtung 28 des GMR-Schichtstapels ist diagonal zur quadratischen Spirale und zeigt von links unten nach rechts oben. Der Bondkontakt 270 verbindet gnd-Kontakt 70, Bondkontakt 291 verbindet Mittelkontakt 91, Bondkontakt 293 verbindet Mittelkontakt 93, Bondkontakt 295 verbindet Mittelkontakt 95, Bondkontakt 297 verbindet Mittelkontakt 97, Bondkontakt 280 verbindet Vcc-Kontakt 80, und die Bondkontakte 225a und 225b verbinden die Enden der Leiterbahn 25 mit der Engstelle 26. Die Größe und Anzahl der Bondkontakte bestimmt im Wesentlichen die Chipgröße. Durch die erfindungsgemäße 360°-Kontaktierung wurden in diesem Beispiel vier Bondkontakte eingespart. Deutlicher wird dieser Effekt beim Vorsehen einer höheren Windungszahl im Sensor 2 zur Zählung größerer Umdrehungszahlen. Bei einem Umdrehungszähler für 30 Umdrehungen werden bei der neuen Art der Kontaktierung, also der erfindungsgemäßen "360°-Kontaktierung", nur noch maximal 32 (Vcc + gnd + 30 Mittelkontakte) statt 62 Bondkontakte, wie nach dem Stand der Technik bislang erforderlich (nämlich: Vcc + gnd + 60 Mittelkontakte), bzw. bei einem 5x-Multiplexing nur noch 16 (nämlich: 5 Vcc + 5 gnd + 6 Mittelkontakte) statt 22 Bondkontakte (nämlich: 5 Vcc + 5 gnd + 12 Mittelkontakte), benötigt. Das hier nicht näher beschriebene multiplexe Auslesen der Wheatstone-Halbbrückensignale erfolgt hintereinander mit einer Taktfrequenz im MHz-Bereich, während die Messintervalle im kHz-Bereich liegen, und somit quasi gleichzeitig. Dies geht einher mit einer Reduzierung der Bondkontakte auf 48% bzw. 27 %. Da die Chipfläche wesentlich von der Größe und der Anzahl der Bondkontakte bestimmt wird, die mit den Spiralen-Kontakten verbunden sind, minimiert dies die Chipfläche pro Sensorelement um 25% bzw. 10%, wie anhand von Layout-Simulationen beispielhaft ermittelt wurde.

Figur 6 zeigt die Verschaltung des Umdrehungssensor 2 nach den Figuren 4 und 5 in vier Wheatstone-Brücken WB1 bis WB4, wobei die Stegwiderstände mit Rij nummeriert wurden, gemäß den in Figur 2 verwendeten Stegnummern. Die Stegwiderstände bilden eine Wheatstone-Halbbrücke. Zur Wheatstone-Vollbrücke werden diese Stegwiderstände verschaltet z.B. mit zwei zusätzlichen, nicht im Sensorelement enthaltenen externen, nicht magnetoresistiven Festwiderständen, die mit dem Namenszusatz "ref" für Referenzwiderstand in Fig. 6 versehen sind:

Die Wheatstone-Brücke WB1 besteht aus den Widerständen 133 (R33), 134 (R34), 233 (Rref33) und 234 (Rref34). Die Widerstände 133 und 134 sind Stege aus der ersten, äußersten Windung der Schleife 27. Die Referenzwiderstände 233 und 234 sind außerhalb des Sensorelementes befindliche Festwiderstände;
Die Wheatstone-Brücke WB2 besteht aus den Widerständen 143 (R43), 144 (R44), 243 (Rref43) und 244 (Rref44). Die Widerstände 143 und 144 sind Stege aus der zweiten Windung der Schleife 27. Die Referenzwiderstände 243 und 244 sind außerhalb des Sensorelementes befindliche Festwiderstände;
Die Wheatstone-Brücke WB3 besteht aus den Widerständen 153 (R53), 154 (R54), 253 (Rref53) und 254 (Rref54). Die Widerstände 153 und 154 sind Stege aus der dritten Windung der Schleife 27. Die Referenzwiderstände 253 und 254 sind außerhalb des Sensorelementes befindliche Festwiderstände;
Die Wheatstone-Brücke WB4 besteht aus den Widerständen 163 (R63), 164 (R64), 263 (Rref63) und 264 (Rref64). Die Widerstände 163 und 164 sind Stege aus der vierten, innersten Windung der Schleife 27. Die Referenzwiderstände 263 und 264 sind außerhalb des Sensorelementes befindliche Festwiderstände.

Im Rahmen der Erfindung werden nun, wie auch in allen anderen Beispielen, die Signalpegel aller Wheatstonebrücken quasi gleichzeitig erfasst und tabellenartig fortlaufend in einem Speicher 9 abgelegt und stehen somit zum nachfolgenden Vergleich mit den quadrantenmäßig abgelegten Sollwerten im Speicher 10 zur Verfügung.

Ein drittes prinzipielles Ausführungsbeispiel der Erfindung ist in Figur 7. dargestellt. Fig. 7 zeigt einen Umdrehungssensor 2, bestehend aus einer Spirale 20, die aus zwei annähernd gleich großen Teilspiralen mit gleichem Drehsinn gebildet ist. Die Enden der Spirale bilden in diesem Beispiel die Spitzen 21 und 22. Die Referenzrichtung 28 des GMR-Schichtstapels ist diagonal zur quadratischen Spirale ausgerichtet und zeigt von links unten nach rechts oben (siehe Pfeil im Spiralenzentrum). Elektrisch wird die Spirale in diesem Beispiel mit fünf Wheatstone-Halbbrücken WHB1 bis WHB5 ausgelesen:

- WHB1 mit den Stegen zwischen dem gnd-Kontakt 71, dem Mittelkontakt 91 und dem Vcc-Kontakt 81 (Windung 1);
- WHB2 mit den Stegen zwischen dem gnd-Kontakt 71, dem Mittelkontakt 93 und dem Vcc-Kontakt 81 (Windung 2);
- WHB3 mit den Stegen zwischen dem gnd-Kontakt 72, dem Mittelkontakt 95 und dem Vcc-Kontakt 82 (Windung 3);
- WHB4 mit den Stegen zwischen dem gnd-Kontakt 72, dem Mittelkontakt 97 und dem Vcc-Kontakt 82 (Windung 4);
- WHB5 mit den Stegen zwischen dem gnd-Kontakt 72, dem Mittelkontakt 99 und dem Vcc-Kontakt 82 (Windung 5).

Über den elektrischen Kontakt 25 mit der Einengung 26 wurde im Beispiel ein Magnetisierungsmuster mit zwei Domänenwänden mit einem Winkelabstand von 540°, wie bereits beschrieben, initialisiert. Die Positionen der Domänenwände DW 111 und DW 112 sollen in diesem Beispiel die Umdrehungszahl Null repräsentieren. Zwischen den DW 111 und DW 112 befinden sich zwei DW-Lücken DWL 221 und DWL 222, die durch Annihilation von zwei Domänenwänden entstanden, so dass zwischen den benachbarten Domänenwänden DW 111 und DW 112 im cw-Sinn ein Abstand >360°, hier wieder 540° eingestellt ist.
Die Magnetisierungsrichtung der Stege in WHB1 und WHB2 ist ccw und der Stege in den WHB3, WHB4 und WHB5 ist cw. Aufgrund der Referenzrichtung 28 des GMR-Schichtstapels sind die Signalpegel der fünf Wheatstone-Halbbrücken im Beispiel:

- WHB1 (Windung 1): L

(fortgesetzt)

- WHB2 (Windung 2): L
- WHB3 (Windung 3): H
- WHB4 (Windung 4): H
- WHB5 (Windung 5): H

Die Ausleseelektronik verarbeitet alle gemessenen Signalpegel der fünf Halbbrücken gleichzeitig z.B. als Signalpegelfolge (SPF) von Windung 1 bis Windung 5 und vergleicht diese mit im Speicher 10 abgespeicherten Sollwerten. Die SPF für Figur 7 ist im dargestellten Beispiel:
L / L / H / H / H. Maßgebend für die Detektion der gezählten Umdrehungen ist der Teil der SPF, der mit dem Magnetisierungsmuster MM korreliert ist, d.h. mit den Positionen der DW 111 und DW 112. Dieser Teil wird nachfolgend als SPF-MM bezeichnet und hat die zwei Signalpegel L / L. Mit dem Transport des MMs durch die Spirale, aufgrund der erfolgten Umdrehungen, wird auch die SPF-MM innerhalb der SPF eineindeutig neu positioniert (vergleiche Figur 9). Es sind mit dem Sensorelement gemäß dem dargestellten Beispiel nach Fig. 7 drei Umdrehungen eineindeutig zählbar. Zur Verdeutlichung zeigt Figur 8 die Domänenwandlage nach drei cw-Umdrehungen. Die DW 111 und DW 112 und die dazwischen liegenden DW-Lücken DWL 221 und DWL 222 wurden zwölf DW-Lagen, d.h. drei Windungen, weiter transportiert, und zwar in die in Fig. 8 dargestellten Positionen. Die Positionen der DW 111 und DW 112 repräsentieren somit die Umdrehungszahl Drei. Die Magnetisierungsrichtung der Stege in WHB4 und WHB5 ist ccw und die der Stege in den WHB1, WHB2 und WHB3 ist cw, auch hier wieder angedeutet durch Pfeile auf den Domänenwandleitbahnen. Die Signalpegel der Wheatstone-Halbbrücken sind nach drei 360°-Umdrehungen:

- WHB1 (Windung 1): H
- WHB2 (Windung 2): H
- WHB3 (Windung 3): H
- WHB4 (Windung 4): L
- WHB5 (Windung 5): L

Die SPF nach drei Umdrehungen ist somit H / H / H / L / L. Verglichen mit dem SPF von Figur 7 (L / L / H / H / H) ist das SPF-MM mit den Pegeln L / L innerhalb der SPF mit jeder gezählten Umdrehung eine Position weiter nach rechts transportiert worden. Dies korreliert mit dem Weitertransport der Domänenwände DW 111 und DW 112 in die nächste Windung bei jeder gezählten Umdrehung. Die Ausbildung des Sensorelements 2 in Form zweier Teilspiralen mit gleichem Windungsdrehsinn hat den Vorteil einer kleineren Ausbildungsmöglichkeit der Gesamtspirale, verglichen bspw. mit einer Ausbildung nach Figur 3 und damit einer Einsparung von erforderlicher Chipfläche.

Zur Verdeutlichung der Auswertung und Bewertung der entsprechend des eingeprägten Domänenwandmusters in Korrelation mit den für jeden Quadranten während der Zählung ermittelten und abgelegten Signalpegelfolgen soll Figur 9 dienen, die das erfindungsgemäße Auswerteverfahren im wesentlichen Teil, anhand des Beispiels nach den Figuren 7 und 8 näher verdeutlicht.
Figur 9 zeigt für das Sensorelement aus Figur 7 und Figur 8 tabellarisch für den vom Quadranten- oder Winkelsensor 3 vorgegebenen Feldwinkel-Quadranten 1 (Figur 9a), Feldwinkel-Quadranten 2 (Figur 9b), Feldwinkel-Quadranten 3 (Figur 9c) und Feldwinkel-Quadranten 4 (Figur 9d) jeweils die Sollwert-Signalpegelfolgen für die Umdrehungen 0, 1, 2 und 3 für die fünf Windungen W1 bis W5 gemäß Fig. 7. Es existiert für den konkreten zum Einsatz gelangenden Sensor somit immer ein eineindeutiges Muster. Für jeden Quadranten existiert ein eigenes signifikantes SPF-MM und je eine eigene eineindeutige SPF für jede Umdrehung. Das signifikante SPF-MM für Quadrant Q1 ist L / L, für Q2 M / L, für Q3 L und für Q4 L / M, wobei H für einen Wheatstone-Halbbrückensignalpegel High-, M für Medium- und L für einen Lowpegel steht. Vorstehend genannte signifikante SPF-MM sind in den Tabellen der Fig. 9 jeweils mittel- oder dunkelgrau hervorgehoben. Dies hat zur Folge, dass für jeden einzelnen Quadranten zumindest eine Subtabelle mit allen SPFs für alle zulässigen (d.h. zählbaren) Umdrehungen erfindungsgemäß vorgehalten wird, die in Figur 9a bis 9d beispielhaft aufgeführt sind. Die Ausleseelektronik 11 bestimmt zuerst den Feldwinkel-Quadranten, in dem sich das System gerade befindet, d.h. die Stellung des rotierenden Elements 4 (bspw. nach Fig. 1). Nach dieser Bestimmung sucht die Ausleseelektronik 11 die dem ausgewählten Quadranten zugehörige Subtabelle und vergleicht danach die gemessene SPF mit den SPF-Sollwerten des entsprechenden Quadranten. Im Beispiel wäre dies der Quadrant 1 (Fig. 9a). Aus dieser Subtabelle ermittelt die Auswerteelektronik 11 danach sofort durch Vergleich der gemessenen Werte im Speicher 9 mit den im Speicher 10 vorgehaltenen Sollwert-Signalpegelfolgen die zugehörige Umdrehungszahl (Übereinstimmung der SPFs), die dann zur Ausgabe/Anzeige gebracht werden kann. Im Beispiel entspricht die Signalpegelfolge gemäß Fig. 7 der Umdrehungszahl Null und die Signalpegelfolge gemäß Fig. 8 der Umdrehungszahl Drei, wie man durch Vergleich mit vorstehenden Erläuterungen leicht sieht. Analog wird verfahren, wenn ein anderer Feldwinkel-Quadrant die Auswahl der zugehörigen Subtabelle vorgibt.

Figur 10 zeigt schematisch die Bestimmung der Umdrehungszahl in einem Ablaufdiagramm 400, wenn das Umdrehungszähler-System 1 eine beliebige, aber unbekannte Umdrehungszahl ermittelt.

- Nach dem Start des Messzyklus
- liest die Elektronik 6 im ersten Schritt den Winkelsensor (WS) 2 und den Umdrehungszahl-Sensor (US) 3 aus und speichert die Werte in den Speichern 8 und 9 als Wert W8 (8a) und Tabelle T9 (9a);
- im 2. Schritt wird von der Verarbeitungseinheit 11 aus dem Winkelsensor-Messwert W8 (8a) der zugehörige Feldwinkel-Quadrant Q1, Q2, Q3 oder Q4 ermittelt;
- im 3. Schritt wird für den ermittelten Quadranten (z.B. Q1) aus dem Speicher 10 mit den Sollwert-Signalpegeltabellen die Subtabelle für den ermittelten Quadranten (z.B. Subtabelle S1 Q1 (10a)) geladen für die zulässigen Umdrehungen i ($0 \leq i \leq n$);
- im 4. Schritt wird von der Verarbeitungseinheit 11 der Laufindex i auf 0 gesetzt
- der 5. Schritt ist ein iterativer Vergleich durch die Verarbeitungseinheit 11 zwischen der gemessenen SPF in Tabelle T9 (9a) mit den Sollwert-SPF (z.B. aus Subtabelle S1 Q1 (10a)) für die Umdrehung i:

    - Stimmen die Werte überein, so gibt die Verarbeitungseinheit 11 im 6. Schritt die Umdrehungszahl i aus oder
    - Wenn die Werte nicht übereinstimmen, so wird im 6. Schritt der Laufindex i um eins erhöht und
    - im 7. wird Schritt geprüft, ob $i > n$ ist:

        - Wenn $i > n$ ist gibt die Verarbeitungseinheit 11 im 8. Schritt einen Fehlerwert aus,
        - ansonsten wird der 5. Schritt wiederholt für die Umdrehung i+1;

Der Messzyklus ist mit der Ausgabe einer Umdrehungszahl oder eines Fehlerwertes beendet. Ein Fehlerwert wird nur ausgegeben, wenn keinerlei Übereinstimmungen zwischen gemessenen und als Sollwert gespeicherten Signalpegelfolgen zu verzeichnen ist. Das ist gleichbedeutend damit, dass sich das in den Umdrehungssensor eingeprägte Domänenwandmuster durch äußere Einflüsse, bspw. zu starke externe Störmagnetfelder etc., verändert hat. In einem solchen, äußerst seltenen Fall, müsste das gewünschte Magnetisierungsmuster neu in den Umdrehungssensor 2 eingeschrieben werden.

Der gesamte Ablauf der Bestimmung von zählbaren Umdrehungszahlen mittels der vorstehend beschriebenen elektronischen Komponenten geschieht in Zeiten, die wesentlich unter denen liegen, in denen sich die auf den Umdrehungssensor 2 einwirkende Richtung des äußeren Magnetfeldes verändert. Typischerweise erfolgt die Messung und Auswertung einer SPF mit MHz-Taktfrequenzen (d.h. innerhalb einer μs), während sich das Magnetfeld maximal mit 1 KHz dreht. In einer μs dreht sich die Richtung des Magnetfeldes somit maximal um 0,3°. Durch diese hohen Auswertegeschwindigkeiten ist es auch möglich, die erfahrenen Umdrehungszahlen, die im stromlosen Betrieb das Magnetisierungsmuster im Sensor 2 verschoben haben, in einigen 10 ns bis maximal 1μs zur Anzeige zu bringen.

Während alle erfindungswesentlichen Baugruppen innerhalb des in Fig. 1 rahmenartig umfassten und mit 1a bezeichneten eigentlichen Umdrehungszählers stecken, sollen nachstehende Figuren das breite Einsatzfeld der erfindungsgemäßen Lösung verdeutlichen.

So zeigt Figur 11 den Umdrehungszähler 1a aus Figur 1 kombiniert mit einem Polrad 5a mit Magnetpolen 4a bis 4l anstelle eines Magneten 4 auf einer Welle 5 gemäß Fig. 1. Wenn das Polrad 5a gedreht wird, erzeugt es am Ort des Winkelsensors WS 3 und des Umdrehungssensors US 2 ein magnetisches Drehfeld, das die Domänenwände des Magnetisierungsmusters im Sensorelement 2 bewegt. Jede Polrad-Position entspricht somit einem Winkelsensor-Messwert und einem Umdrehungszähler-Messwert. Der Umdrehungszähler zählt die Anzahl der vorbei bewegten Magnetpol-Paare. Dies ist analog zum Zählen von Umdrehungen des Magneten 4 gemäß Fig. 1.

Figur 12 zeigt den Umdrehungszähler 1a aus Fig. 1 kombiniert mit einem Linear-Maßstab 5b mit Magnetpolen 4a bis 4l anstelle eines Magneten 4 auf einer Welle 5 gemäß Fig. 1. Der Linear-Maßstab 5b mit im Beispiel zwölf Magnetpolen (6 Nordpole abwechselnd mit 6 Südpolen) 4a bis 4l repräsentiert auch andere Linear-Maßstäbe mit mehr oder weniger Magnetpolen. Wenn der Maßstab 5b relativ zum Umdrehungszähler 1a vorbei bewegt wird, erzeugt er am Ort des Winkelsensors WS 3 und des Umdrehungssensors US 2 ein magnetisches Drehfeld, das die Domänenwände des eingeprägten Magnetisierungsmusters im Sensorelement 2 bewegt. Jede Maßstab-Position entspricht somit einem Winkelsensor-Messwert und einem Umdrehungszähler-Messwert. Der Umdrehungszähler zählt die Anzahl der vorbei bewegten Magnetpol-Paare. Dies ist analog zum Zählen von Umdrehungen des Magneten 4 gemäß Fig. 1.

Schließlich zeigen die Figur 13a+b beispielhaft den Einsatz eines Sensorelementes 2 mit TMR-Kontakten mit der erfindungsgemäßen "360°-Kontaktierung". Die Spirale 27 besteht in diesem Fall aus einem weichmagnetischen Material, z.B. Permalloy.

Figur 13a zeigt eine beispielhafte vierwindige, in sich geschlossene Schleife 27 in Draufsicht. Das Sensorelement 2 wird ausgelesen durch Potentialmessungen mit vier Wheatstone-Halbbrücken WHB1 bis WHB4:

- Die WHB1 besteht aus dem Steg 33 mit dem gnd-Tunnelkontakt 71, dem Steg 34 mit dem Vcc-Tunnelkontakt 81 und dem Mittelkontakt 91, der die viertelkreisförmige Ecke zwischen Steg 33 und Steg 34 sowie Teile dieser Stege bedeckt;
- WHB2 besteht aus den Steg 43 mit dem gnd-Tunnelkontakt 72, dem Steg 44 mit dem Vcc-Tunnelkontakt 82 und dem Mittelkontakt 93, der die viertelkreisförmige Ecke zwischen Steg 43 und Steg 44 sowie Teile dieser Stege bedeckt;
- WHB3 besteht aus den Steg 53 mit dem gnd-Tunnelkontakt 73, dem Steg 54 mit dem Vcc-Tunnelkontakt 83 und dem Mittelkontakt 95, der die viertelkreisförmige Ecke zwischen Steg 53 und Steg 54 sowie Teile dieser Stege bedeckt;
- WHB4 besteht aus den Steg 63 mit dem gnd-Tunnelkontakt 74, dem Steg 64 mit dem Vcc-Tunnelkontakt 84 und dem Mittelkontakt 97, der die viertelkreisförmige Ecke zwischen Steg 63 und Steg 64 sowie Teile dieser Stege bedeckt. (In Fig. 13a nicht bezeichnete Bezugszeichen sind in Fig. 14 ersichtlich)

Figur 13b zeigt den Steg 33 in einem seitlichen Schnitt durch Fig. 13a stellvertretend für alle Stege mit Tunnelkontakt. Der Steg 33 besteht aus einem weichmagnetischen Material 501, bspw. Permalloy, geschützt mit einer Oxidschicht 504a und 504b. In der Stegmitte ist der gnd-Tunnelkontakt 71 positioniert. Der Tunnelkontakt besteht aus einer Permalloylage 501, einer Tunnelbarriere 502 (z.B. $Al_2O_3$ oder MgO), einem hartmagnetischen Schichtstapel 503, in die die Referenzrichtung (28 in Figur 13a) eingeschrieben ist, und aus einer Goldelektrode 505. Rechts auf dem Steg 33 befindet sich direkt auf dem Permalloy 501 der Mittelkontakt 91 aus Gold. Der Stromfluss beim Tunnelkontakt erfolgt von der Elektrode 505 durch den hartmagnetischen Schichtstapel und durch die Barriere 502 in das Permalloy 501. Typische TMR-Kontakte erreichen Widerstandsänderungen von >100% zwischen paralleler und antiparalleler Magnetisierung der weichmagnetischen und der hartmagnetischen Lage im TMR-Kontakt, d.h. in Abhängigkeit von der jeweiligen Position der Domänenwände 111, 112. Die Initialisierung des erfindungsgemäßen Domänenwandmusters als auch die Auswertung und Bestimmung der aktuellen Umdrehungszahl erfolgt in diesem Beispiel analog zu den zu den Figuren 5ff. bereits beschriebenen Maßgabe und bedarf hier deshalb keiner Wiederholung.

Figur 14 zeigt den Umdrehungssensor von Figur 13a mit einer abgewandelten Kontaktierung, bei der die Widerstände ausgelesen werden. Elektrisch kontaktiert wird diese Schleife mit den gnd-Kontakten 71, 72, 73 und 74 und den Vcc-Kontakten 81, 82, 83 und 84, jeweils ein gnd und ein Vcc-Kontakt auf einer Windung. Damit der TMR-Effekt genutzt wird, müssen z.B. die Vcc-Kontakte jeweils die weichmagnetische Lage und die gnd-Kontakte jeweils die hartmagnetische Lage kontaktieren (analog zur Figur 13b, bei der der Mittelkontakt 91 die weichmagnetische Lage 501 und der gnd-Tunnelkontakt 71 die hartmagnetische Lage kontaktiert), oder umgekehrt. Die Kontakte können abweichend zur Figur 14 anstatt über den Ecken auf den Stegen positioniert sein, vorzugsweise auf gegenüberliegenden Stegen. Z.B. die Vcc-Kontakte 81, 82, 83 und 84 auf den Stegen 31, 41, 51 und 61 und die gnd-Kontakte 71, 72, 73 und 74 auf den Stegen 33, 43, 53 und 63.

Der Magnetisierungszustand des Sensorelementes wird hier durch Widerstandsmessung jeder einzelnen Windung ausgelesen:

Die äußere, erste Windung W1 bilden die Stege 31, 32, 33 und 34 mit dem gnd-Kontakt 71 und dem Vcc-Kontakt 81;
Die zweite Windung W2 bilden die Stege 41, 42, 43 und 44 mit dem gnd-Kontakt 72 und dem Vcc-Kontakt 82;
Die dritte Windung W3 bilden die Stege 51, 52, 53 und 54 mit dem gnd-Kontakt 73 und dem Vcc-Kontakt 83;
Die vierte, innerste Windung W4 bilden die Stege 61, 62, 63 und 64 mit dem gnd-Kontakt 74 und dem Vcc-Kontakt 84;
Auch in diesem Beispiel beträgt der Abstand zwischen den zwei benachbarten Domänenwänden DW 111 und DW 112 540° in cw-Richtung betrachtet.

Alle in der Beschreibung, den Ausführungsbeispielen und/oder den nachfolgenden Zeichnungen erkenntlichen Merkmale können einzeln als auch in beliebiger Kombination miteinander erfindungswesentlich sein.

<u>Bezugszeichenliste</u>

| | |
|---|---|
| 1 | Umdrehungszähler-System |
| 1a | Umdrehungszähler |
| 2 | Umdrehungssensor US |
| 3 | Winkelsensor WS |
| 4 | Magnetsystem |

| | |
|---|---|
| | 4a, 4c, 4e 4g, 4i 4k Nordpole |
| | 4b, 4d, 4f, 4h, 4j, 4l Südpole |
| 5 | drehende Welle |
| 5a | Polrad |
| 5b | Linear-Maßstab |
| 6 | Elektronik |
| 7 | Spannungsversorgungen |
| 8 | Speicher für den Messwert des Winkelsensors |
| | 8a Messwert W8 vom Winkelsensor |
| 9 | Speicher für die Messwerte des Umdrehungssensors |
| | 9a Tabelle T9 mit Messwerten vom Umdrehungssensor |
| 10 | Speicher für tabellenartig abgespeicherte Sollwert-SPF (Signalpegelfolgen) des Umdrehungssensors |
| | 10a-10d Subtabellen mit Sollwerten für den 1. bis 4. Feldwinkel-Quadranten |
| 11 | Verarbeitungseinheit |
| 20 | Spirale |
| 21, 22 | angespitzte Enden einer Spirale |
| 25 | Leiterbahn zum Initialisieren eines Magnetisierungsmusters |
| 26 | Verengung in Leiterbahn 25 |
| 27 | mehrfach verwundene, in sich geschlossene Schleife |
| 28 | Richtung der Referenzmagnetisierung |
| 31, 32, 33, 34 | Stege der äußersten, ersten Windung |
| 35, 36, 37, 38 | DW-Lagen in der äußersten, ersten Windung |
| 41, 42, 43, 44 | Stege der zweiten Windung |
| 45, 46, 47, 48 | DW-Lagen in der zweiten Windung |
| 51, 52, 53, 54 | Stege der dritten Windung |
| 55, 56, 57, 58 | DW-Lagen in der dritten Windung |
| 63, 64 | Stege er vierten Windung |
| 65 | DW-Lage in der vierten Windung |
| 70, 71, 72, 73, 74 | gnd-Kontakte |
| 80, 81, 82, 83, 84 | Vcc-Kontakte |
| 91, 93, 95, 97, 99 | Mittelkontakte der unterschiedlichen Windungen |
| 111a | 1. DW bei einem MM mit 1 DW |
| 111 | 1. DW bei einem MM mit 2 oder 6 Domänenwänden |
| 112 | 2. DW bei einem MM mit 2 oder 6 Domänenwänden |
| 113 | 3. DW bei einem MM mit 6 Domänenwänden |
| 114 | 4. DW bei einem MM mit 6 Domänenwänden |
| 115 | 5. DW bei einem MM mit 6 Domänenwänden |
| 116 | 6. DW bei einem MM mit 6 Domänenwänden |
| 133 | Widerstand R33 (Steg 33) in der ersten Windung |
| 134 | Widerstand R34 (Steg 34) in der ersten Windung |
| 143 | Widerstand R43 (Steg 43) in der zweiten Windung |
| 134 | Widerstand R44 (Steg 44) in der zweiten Windung |
| 153 | Widerstand R53 (Steg 53) in der dritten Windung |
| 154 | Widerstand R54 (Steg 54) in der dritten Windung |
| 163 | Widerstand R63 (Steg 63) in der vierten Windung |
| 164 | Widerstand R64 (Steg 64) in der vierten Windung |
| 202 | Chip mit Sensorelement 2 |
| 221, 222 | DW-Lücken |
| 225a | erster Bondkontakt angebunden an Kontakt 25 |
| 225b | zweiter Bondkontakt angebunden an Kontakt 25 |
| 233 | externer Widerstand Rref33 zur ersten Windung |
| 234 | externer Widerstand Rref34 zur ersten Windung |
| 243 | externer Widerstand Rref43 zur zweiten Windung |
| 244 | externer Widerstand Rref44 zur zweiten Windung |
| 253 | externer Widerstand Rref53 zur dritten Windung |
| 254 | externer Widerstand Rref54 zur dritten Windung |
| 263 | externer Widerstand Rref63 zur vierten Windung |

| | |
|---|---|
| 264 | externer Widerstand Rref64 zur vierten Windung |
| 270 | Bondkontakt angebunden an gnd-Kontakt 70 |
| 280 | Bondkontakt angebunden an Vcc-Kontakt 80 |
| 291 | Bondkontakt angebunden an Mittelkontakt 91 |
| 293 | Bondkontakt angebunden an Mittelkontakt 93 |
| 295 | Bondkontakt angebunden an Mittelkontakt 95 |
| 297 | Bondkontakt angebunden an Mittelkontakt 97 |
| 301 | gezoomte Ecke zwischen Steg 51 und Steg 44 |
| 302 | Viertelkreis-ähnlicher Polygonzug |
| 400 | Ablaufdiagramm |
| 501 | weichmagnetische Schicht |
| 502 | Tunnelbarriere |
| 503 | hartmagnetischer Schichtstapel |
| 504a | Isolationsschicht |
| 504b | Isolationsschicht |
| 505 | Goldelektrode auf Tunnelkontakt |

## Patentansprüche

**1.** Magnetischer Umdrehungszähler zur Bestimmung einer vorgebbaren Anzahl zu bestimmender Umdrehungen n eines äußeren Magnetfelds, erzeugt durch ein rotierendes Element (4), respektive einer vorbei bewegbaren Anzahl n an Magnetpolen eines rotierenden Polrades (5a), respektive eines vorbei bewegbaren linearen magnetischen Maßstabes (5b), beinhaltend einen Umdrehungssensor (2), der magnetische Domänenwandleitbahnen beinhaltet, die aus offenen Spiralen (20) oder in sich geschlossenen mehrfach verwundenen Schleifen (27) bestehen, die durch einen GMR-Schichtstapel oder einer weichmagnetischen Schicht mit lokal vorhandenen TMR-Schichtstapeln gebildet sind und in die magnetische 180°-Domänenwände einbringbar und -durch Messung des elektrischen Widerstands vorgebbarer Spiralen- oder Schleifenabschnitte- lokalisierbar sind, wobei

- in die Domänenwandleitbahnen eine einzige Domänenwand (111a) oder mindestens zwei magnetische Domänenwände derart eingebracht sind, dass die mindestens zwei Domänenwände (111, 112) durch Mittel (25, 26) zum Erzeugen, Pinnen oder definierten Löschen von Domänenwänden in einen definierten Abstand von größer als 360° zueinander -bezogen auf ihre Ortsveränderung von erster zu zweiter Position, bei Drehung des äußeren Magnetfeldes um den Winkel von größer als 360°- gebracht und dauerhaft so zueinander beabstandet sind und
- auf den Domänenwandleitbahnen elektrische Kontakte derart vorgesehen sind, dass die Domänenwandleitbahnen diagonal gegenüber liegend von je einem gnd- (70, 71, 72) und einem Vcc-Kontakt (80, 81, 82) gemeinsam, bzw. in Vcc-Kontakt-Gruppen und gnd-Kontakt-Gruppen bei Multiplex-Auslesung, erfasst sind und ausschließlich einseitig und im Wesentlichen mittig zwischen genanntem gnd- (70, 71, 72) und Vcc-Kontakt (80, 81, 82) separate Kontakte (91, 93, 95, 97, 99) auf jedem einzelnen Domänenwandleitbahnabschnitt vorgesehen sind, bzw. bei Multiplex-Auslesung in Gruppen von Kontakten, die mehrere Windungen als Wheatstone-(Halbbrücken)-Mittelkontakt kontaktieren, und
- genannte Kontakte nebst zugehöriger, von ihnen erfasster Domänenwandleitbahnabschnitten zu separaten aber gemeinsam auslesbaren Wheatstonehalbbrücken verschaltet sind, wobei die von den Wheatstonehalbbrücken ermittelten Widerstandsverhältnisse als Signalpegel sämtlich in einem Speicher (9) als Tabelle (9a) abgelegt sind, der zur Ermittlung der aktuellen Umdrehungszahl fortlaufend mit in einem weiteren Speicher (10) abgelegten tabellenartigen Sollwertmustern (10a, 10b, 10c und 10d) für jede zulässige Umdrehung i ($0 \leq i \leq n$) vergleichbar ist, und
- für die zu bestimmende Umdrehungszahl i diejenige ausgebbar ist, für die die gemessenen Widerstandsverhältnisse in Tabelle (9a) mit dem Sollwertmuster im Speicher (10) übereinstimmt, ermittelt durch eine entsprechende Verarbeitungseinheit (11),

**2.** Magnetischer Umdrehungszähler zur Bestimmung einer vorgebbaren Anzahl zu bestimmender Umdrehungen n eines äußeren Magnetfelds, erzeugt durch ein rotierendes Element (4), respektive einer vorbei bewegbaren Anzahl n an Magnetpolen eines rotierenden Polrades (5a), respektive eines vorbei bewegbaren linearen magnetischen Maßstabes (5b), beinhaltend einen Umdrehungssensor (2), der magnetische Domänenwandleitbahnen beinhaltet, die aus offenen Spiralen (20) oder in sich geschlossenen mehrfach verwundenen Schleifen (27) bestehen, die durch einen GMR-Schichtstapel oder einer weichmagnetischen Schicht mit lokal vorhandenen TMR-Schichtstapeln gebildet sind und in die magnetische 180°-Domänenwände einbringbar und -durch Messung des elektrischen Widerstands vorgebbarer Spiralen- oder Schleifenabschnitte- lokalisierbar sind, wobei

- in die Domänenwandleitbahnen eine einzige Domänenwand (111a) oder mindestens zwei magnetische Domänenwände derart eingebracht sind, dass die mindestens zwei Domänenwände (111, 112) durch Mittel (25, 26) zum Erzeugen, Pinnen oder definierten Löschen von Domänenwänden in einen definierten Abstand von größer als 360° zueinander -bezogen auf ihre Ortsveränderung von erster zu zweiter Position, bei Drehung des äußeren Magnetfeldes um den Winkel von größer als 360°- gebracht und dauerhaft so zueinander beabstandet sind und
- auf den Domänenwandleitbahnen elektrische Kontakte derart vorgesehen sind, dass die Domänenwandleitbahnen diagonal gegenüber liegend von je einem gnd-Kontakt und von je einem Vcc-Kontakt pro Windung, bzw. bei Multiplex-Auslesung von einem gemeinsamen gnd-Kontakt (70) und von je einem Vcc-Kontakt (81, 82, 83, 84) pro Windung oder von einem gemeinsamen Vcc-Kontakt und von je einem gnd-Kontakt pro Windung, erfasst sind, und
- die über diese Kontakte ermittelten Widerstandsverhältnisse als Signalpegel sämtlich in einem Speicher (9) als Tabelle (9a) abgelegt sind, der zur Ermittlung der aktuellen Umdrehungszahl fortlaufend mit in einem weiteren Speicher (10) abgelegten tabellenartigen Sollwertmustern (10a, 10b, 10c und 10d) für jede zulässige Umdrehung i ($0 \leq i \leq n$) vergleichbar ist, und
- für die zu bestimmende Umdrehungszahl i diejenige ausgebbar ist, für die die gemessenen Widerstandsverhältnisse in Tabelle (9a) mit dem Sollwertmuster im Speicher (10) übereinstimmt, ermittelt durch eine entsprechende Verarbeitungseinheit (11),

**3.** Magnetischer Umdrehungszähler nach Anspruch 1 oder 2, beinhaltend einen Drehwinkelsensor (3), respektive Quadrantensensor, wobei das Signal (8a) des Drehwinkelsensors (3), respektive Quadrantensensors, die Subtabelle (10a, 10b, 10c oder 10d) bestimmt, mit der die gemessenen Widerstandsverhältnisse in Tabelle (9a) verglichen werden.

**4.** Magnetischer Umdrehungszähler nach Anspruch 1 oder 2, wobei die, die Domänenwandleitbahnen bildenden offenen Spiralen oder in sich geschlossenen mehrfach verwundenen Schleifen im Wesentlichen rhombusförmig ausgebildet sind, wobei die genannten Kontakte (70, 71, 72; 80, 81, 82; 91, 93, 95, 97, 99) die Eckbereiche der Rhomben erfassen.

**5.** Magnetischer Umdrehungszähler nach Anspruch 1 oder 2, wobei der definierte Abstand der zumindest zwei benachbarten Domänenwände (111, 112) zu 540° festgelegt ist.

**6.** Magnetischer Umdrehungszähler nach Anspruch 1 oder 2, wobei die Domänenwandleitbahnen durch offene Spiralen mit beidseitig angespitzten Enden (21, 22) gebildet sind.

**7.** Magnetischer Umdrehungszähler nach Anspruch 1 oder 2, wobei die Mittel zum Erzeugen, Pinnen oder definierten Löschen von Domänenwänden durch eine zusätzliche, mindestens eine Windung der Domänenwandleitbahn erfassende und an der die Domänenwandleitbahn überbrückenden Kontaktstelle (26) verjüngt ausgeführte Leiterbahn (25) gebildet sind, die bei Strombeaufschlagung die Erzeugung eines Oerstedtfeldes hinreichender Größe gewährleistet.

**8.** Verfahren zur Bestimmung von mit einem magnetischen Umdrehungszähler nach Anspruch 1 oder 2 ermittelbaren ganzen Umdrehungszahlen, wobei

- in die Domänenwandleitbahnen zunächst ein Domänenmuster mit nur einer einzigen Domänenwand (111a) oder mit definierter Beabstandung von Domänenwänden eingeprägt wird, wobei der Abstand von mindestens zwei benachbarten Domänenwänden (111, 112) größer als 360° -bezogen auf ihre Ortsveränderung von erster zu zweiter Position, bei Drehung des rotierenden Elements (4) um einen Winkel von größer als 360°- festgelegt wird und
- entsprechend dieses vorgegebenen eingeprägten Domänenwandmusters in einem Sollwertspeicher (10) für alle möglichen mit dem magnetischen Umdrehungszähler ermittelbaren vollen 360°-Umdrehungen i ($0 \leq i \leq n$) und aller damit verbundenen geänderten Domänenwandlagen, alle von den Wheatstonehalbbrücken oder Domänenwandleitbahnen zu erwartenden Signalpegel-Sollwerte tabellenartig in einem Speicher (10) einmalig abgelegt werden und
- in einem zweiten Speicher (9) alle momentan von den Wheatstonehalbbrücken oder Domänenwandleitbahnen während der aktuellen Zählung die zugehörigen Werte des Umdrehungssensors (2) in einer Tabelle (9a) abgelegt werden und
- diese Messwerte (9a) fortlaufend mit den jeweiligen Signalpegel-Sollwerten im Sollwertspeicher (10) verglichen und
- bei in beiden Speichern (9, 10) übereinstimmenden Tabellenwerten als ermittelte Umdrehungszahl i ausgegeben werden.

**9.** Verfahren nach Anspruch 8, wobei

- im Sollwertspeicher (10) für jede einzelne mit dem Umdrehungszähler zählbaren Umdrehung i Signalpegel-Sollwerte in zumindest vier Subtabellen (10a, 10b, 10c und 10d) für vier Feldwinkelquadranten abgespeichert werden,
- der Messwert (W8 (8a)) von einem Drehwinkelsensor (3), respektive von einem Quadrantensensor, die zugehörige Subtabelle determiniert mit der
- die Messwerte (9a) vom Umdrehungssensor (2) fortlaufend verglichen werden, um die zugehörige Umdrehungszahl zu ermitteln.

## Claims

**1.** A magnetic revolution counter for determining a predefinable number n of revolutions to be determined of an outer magnetic field, generated by a rotating element (4), or a number n of magnetic poles of a rotating magnet wheel (5a) that can be moved past, or a linear magnetic scale (5b) that can be moved past, comprising a revolution sensor (2), which includes magnetic domain wall conductors composed of open spirals (20) or closed, multiply-wound loops (27), which are formed by a GMR layer stack or a soft magnetic layer comprising locally present TMR layer stacks and in which magnetic 180° domain walls can be introduced and located by measuring the electrical resistance of predefinable spiral or loop sections, whereby

- a single domain wall (111a) is, or at least two magnetic domain walls are, introduced into the domain wall conductors such that the at least two domain walls (111, 112), by way of means (25, 26) for generating, pinning or deleting, in a defined manner, domain walls, are brought into a defined separation of greater than 360° with respect to one another, based on the change in location thereof from a first to a second position, with a rotation of the outer magnetic field by the angle of greater than 360°, and are permanently thus spaced apart from one another, and
- electrical contacts are provided on the domain wall conductors such that the domain wall conductors, located diagonally opposed, are captured by a respective GND contact (70, 71, 72) and VCC contact (80, 81, 82) collectively, or in VCC contact groups and GND contact groups with a multiplex read-out, and separate contacts (91, 93, 95, 97, 99) are provided on each individual domain wall conductor section solely on one side and substantially centrally between the aforementioned GND contact (70, 71, 72) and VCC contact (80, 81, 82), or, with a multiplex read-out, in groups of contacts that contact a plurality of windings as Wheatstone (half bridge) center contacts, and
- the aforementioned contacts, together with associated domain wall conductor sections captured thereby, are interconnected to form Wheatstone half bridges that are separate, but can be read out together, wherein the resistance conditions ascertained by the Wheatstone half bridges are all stored as a signal level in a memory (9) in the form of a table (9a), which for the determination of the present revolution number can be continuously compared to tabular target value patterns (10a, 10b, 10c and 10d) stored in a further memory (10) for each permissible revolution i ($0 \leq i \leq n$), and
- for the revolution number i to be determined, that for which the measured resistance conditions in the table (9a) agree with the target value pattern in the memory (10), ascertained by a corresponding processing unit (11), can be output.

**2.** A magnetic revolution counter for determining a predefinable number n of revolutions to be determined of an outer magnetic field, generated by a rotating element (4), or by a number n of magnetic poles of a rotating magnet wheel (5a) that can be moved past, or by a linear magnetic scale (5b) that can be moved past, comprising a revolution sensor (2), which includes magnetic domain wall conductors composed of open spirals (20) or closed, multiply-wound loops (27), which are formed by a GMR layer stack or a soft magnetic layer comprising locally present TMR layer stacks and in which magnetic 180° domain walls can be introduced and located by measuring the electrical resistance of predefinable spiral or loop sections, whereby

- a single domain wall (111a) is, or at least two magnetic domain walls are, introduced into the domain wall conductors such that the at least two domain walls (111, 112), by way of means (25, 26) for generating, pinning or deleting, in a defined manner, domain walls, are brought into a defined separation of greater than 360° with respect to one another, based on the change in location thereof from a first to a second position, with a rotation of the outer magnetic field by the angle of greater than 360°, and are permanently thus spaced apart from one another, and
- electrical contacts are provided on the domain wall conductors such that the domain wall conductors, located diagonally opposed, are captured by a respective GND contact and a respective VCC contact per winding or, with a multiplex read-out, are captured by a shared GND contact (70) and a respective VCC contact (81, 82, 83, 84) per winding, or by a shared VCC contact and a respective GND contact per winding, and
- the resistance conditions ascertained by way of these contacts are all stored as a signal level in a memory (9) in the form of a table (9a), which for the determination of the present revolution number can be continuously compared to tabular target value patterns (10a, 10b, 10c and 10d) stored in a further memory (10) for each permissible revolution i ($0 \leq i \leq n$), and
- for the revolution number i to be determined, that for which the measured resistance conditions in the table (9a) agree with the target value pattern in the memory (10), ascertained by a corresponding processing unit (11), can be output.

**3.** The magnetic revolution counter according to claim 1 or 2, comprising a rotation angle sensor (3), or a quadrant sensor, whereby the signal (8a) of the rotation angle sensor (3), or of the quadrant sensor, determines the sub-table (10a, 10b, 10c or 10d) to which the measured resistance conditions in the table (9a) are compared.

**4.** The magnetic revolution counter according to claim 1 or 2, whereby the open spirals or the closed, multiply-wound loops forming the domain wall conductors have a substantially rhombus-shaped design, wherein the aforementioned contacts (70, 71, 72; 80, 81, 82; 91, 93, 95, 97, 99) capture the corner regions of the rhombuses.

**5.** The magnetic revolution counter according to claim 1 or 2, whereby the defined separation between the at least two neighboring domain walls (111, 112) is established at 540°.

**6.** The magnetic revolution counter according to claim 1 or 2, whereby the domain wall conductors are formed by open spirals having pointed ends (21, 22) at both sides.

**7.** The magnetic revolution counter according to claim 1 or 2, whereby the means for generating, pinning or deleting domain walls, in a defined manner, are formed by an additional conductor (25), which captures at least one winding of the domain wall conductor and has a tapered design at the contact point (26) bridging the domain wall conductor and which ensures that an Oersted field having a sufficient magnitude is generated when a current is applied.

**8.** A method for determining integral revolution numbers ascertainable by way of a magnetic revolution counter according to claim 1 or 2, whereby

- initially, a domain pattern including only a single domain wall (111a) or having a defined separation of domain walls is impressed into the domain wall conductors, wherein the separation of at least two neighboring domain walls (111, 112) is established at greater than 360°, based on the change in location thereof from a first to a second position, with a rotation of the rotating element (4) by an angle of greater than 360°, and
- corresponding to this predefined impressed domain wall pattern, all signal level target values to be expected from the Wheatstone half bridges or domain wall conductors are stored once in tabular form in a memory (10) in a target value memory (10) for all possible full 360° revolutions ($0 \leq i \leq n$) ascertainable by way of the magnetic revolution counter and all associated changed domain wall positions,
- and all the associated values of the revolution sensor (2) presently ascertained by the Wheatstone half bridges or domain wall conductors during the presen count are stored in a table (9a) in a second memory (9), and
- these measured values (9a) are continuously compared to the respective signal level target values in the target value memory (10), and
- are output as the ascertained revolution number i when the tabular values in the two memories (9, 10) agree with one another.

**9.** The method according to claim 8, whereby

- signal level target values are stored in at least four sub-tables (10a, 10b, 10c and 10d) for four field angle quadrants in the target value memory (10) for each individual revolution i countable by way of the revolution counter,
- the measured value (W8 (8a)) from an angle sensor (3), or from a quadrant sensor, determines the associated sub-table to which
- the measured values (9a) from the revolution sensor (2) are continuously compared so as to ascertain the associated revolution number.

**Revendications**

1. Compte-tours magnétique destiné à la détermination d'un nombre prédéfinissable de tours n à déterminer d'un champs magnétique externe généré par un élément (4) rotatif, ou bien d'un nombre n de pôles magnétiques d'une roue polaire (5a) rotative en passage, ou bien d'une échelle linéaire (5b) magnétique en passage, comprenant un capteur de tours (2) lequel comprend des pistes conductrices magnétiques de parois de domaine, lesquelles consistent en spirales (20) ouvertes ou en boucles (27) fermées à plusieurs enroulements, lesquelles sont formées par un empilement de couches GMR ou par une couche magnétique douce à empilements TMR locaux et dans lesquelles peuvent être intégrées des parois de domaines magnétiques à 180° et qui peuvent être localisées en mesurant la résistance électrique de secteurs prédéfinissables des spirales ou des boucles, dans lequel

   - une seule paroi de domaine (111a) ou au moins deux parois de domaine magnétiques sont introduites dans les pistes conductrices des parois de domaine de manière à ce que les au moins deux parois de domaine (111, 112), par des moyens (25, 26) pour la génération, l'ancrage ou l'effacement défini de parois de domaine, soient amenées à un écart défini supérieur à 360° l'une par rapport à l'autre relativement à leur déplacement de la première à la deuxième position lors de la rotation du champ magnétique externe autour d'un angle supérieur à 360° et soient ainsi espacées en permanence l'une par rapport à autre, et
   - des contacts électriques sont prévus sur les pistes conductrices des parois de domaine de manière à ce que les pistes conductrices des parois de domaine soient saisies en commun et en positions diagonalement opposées, chacune par un contact gnd (70, 71, 72) et un contact Vcc (80, 81, 82), ou, lors d'une lecture multiplexée, par les groupes de contacts Vcc et des groupes de contacts gnd, et des contacts séparés (91, 93, 95, 97, 99) sont prévus sur chaque secteur des pistes conductrices des parois de domaine uniquement d'un côté et sensiblement centrés entre lesdits contacts gnd (70, 71, 72) et lesdits contacts (80, 81, 82) ou, lors d'une lecture multiplexée, des groupes de contacts qui contactent plusieurs enroulements en tant que contact central du (demi-pont) Wheatstone, et
   - lesdits contacts ainsi que les secteurs des pistes conductrices des parois de domaine associés saisis par ceux-ci sont connectés en demi-ponts Wheatstone séparés, mais lisibles en commun, les rapports de résistances déterminés par les demi-ponts Wheatstone étant enregistrés sous forme d'un tableau (9a) dans une mémoire (9) en tant que niveau de signal, qui, afin de déterminer le nombre de tours actuel, peut être comparé en continu pour chaque tour valide i ($0 \leq i \leq n$) avec les schémas des valeurs de consigne (10a, 10b, 10c et 10d) enregistrés dans une autre mémoire (10), et
   - le nombre de tours i pouvant être délivré est celui pour lequel les rapports de résistances mesurés figurant dans le tableau (9a) coïncident avec le schéma des valeurs de consigne enregistré dans la mémoire (10), déterminé par l'unité de traitement (11).

2. Compte-tours magnétique destiné à la détermination d'un nombre prédéfinissable de tours n à déterminer d'un champs magnétique externe généré par un élément (4) rotatif, ou bien d'un nombre n de pôles magnétiques d'une roue polaire (5a) rotative en passage, ou bien d'une échelle linéaire (5b) magnétique en passage, comprenant un capteur de tours (2) lequel comprend des pistes conductrices magnétiques de parois de domaine, lesquelles consistent en spirales (20) ouvertes ou en boucles (27) fermées à plusieurs enroulements, lesquelles sont formées par un empilement de couches GMR ou par une couche magnétique douce à empilements TMR locaux et dans lesquelles peuvent être intégrées des parois de domaines magnétiques à 180° magnétiques et qui peuvent être localisées en mesurant la résistance électrique de secteurs prédéfinissables des spirales ou des boucles, dans lequel

   - une seule paroi de domaine (111a) ou au moins deux parois de domaine magnétiques sont introduites dans les pistes conductrices des parois de domaine de manière à ce que les au moins deux parois de domaine (111, 112), par des moyens (25, 26) pour la génération, l'ancrage ou l'effacement défini de parois de domaine, soient amenées à un écart défini supérieur à 360° l'une par rapport à l'autre relativement à leur déplacement de la première à la deuxième position lors de la rotation du champ magnétique externe autour d'un angle supérieur à 360° et soient ainsi espacées en permanence l'une par rapport à autre, et

- des contacts électriques sont prévus sur les pistes conductrices des parois de domaine de manière à ce que les pistes conductrices des parois de domaine soient saisies en positions diagonalement opposées, chacune par un contact gnd et chacune par un contact Vcc par enroulement ou, lors d'une lecture multiplexée, chacune par un contact gnd (70) commun et un contact Vcc (81, 82, 83, 84) par enroulement ou par un contact Vcc commun et par un contact gnd par enroulement, et
- les rapports de résistances déterminés via ces contacts sont enregistrés en tant que niveau de signal sous forme d'un tableau (9a) dans une mémoire (9), qui, afin de déterminer le nombre de tours actuel, peut être comparé en continu pour chaque tour valide i ($0 \leq i \leq n$) avec des schémas des valeurs de consigne (10a, 10b, 10c et 10d) enregistrés dans une autre mémoire (10), et
- le nombre de tours i à déterminer pouvant être délivré est celui pour lequel les rapports de résistances mesurés figurant dans le tableau (9a) coïncident avec le schéma des valeurs de consigne enregistré dans la mémoire (10), déterminé par l'unité de traitement (11).

**3.** Compte-tours magnétique selon la revendication 1 ou 2, comprenant un capteur d'angle de rotation (3) ou un capteur à quadrants, dans lequel
le signal (8a) du capteur d'angle de rotation (3) ou du capteur à quadrants détermine le sous-tableau (10a, 10b, 10c ou 10d) utilisé pour comparer les rapports de résistances mesurés enregistrés dans le tableau (9a).

**4.** Compte-tours magnétique selon la revendication 1 ou 2, dans lequel les spirales ouvertes ou les boucles fermées à plusieurs enroulements sont sensiblement en forme de losange, lesdits contacts (70, 71, 72; 80, 81, 82; 91, 93, 95, 97, 99) saisissant les zones des angles des losanges.

**5.** Compte-tours magnétique selon la revendication 1 ou 2, dans lequel l'écart défini des au moins deux parois de domaine (111, 112) adjacentes est défini par une valeur de 540°.

**6.** Compte-tours magnétique selon la revendication 1 ou 2, dans lequel les pistes conductrices des parois de domaine sont formées par des spirales ouvertes taillées en pointe aux deux extrémités (21, 22).

**7.** Compte-tours magnétique selon la revendication 1 ou 2, dans lequel les moyens pour la génération, l'ancrage ou l'effacement défini de parois de domaine sont formés par une piste conductrice (25) additionnelle effilée à la position du point de contact (26) pontant la piste conductrice de la paroi de domaine et saisissant au moins un enroulement de la piste conductrice de la paroi de domaine et qui assure la génération d'un champ Œrsted d'une ampleur suffisante lors de sa mise sous courant.

**8.** Procédé destiné à la détermination de nombres entiers de tours qui peuvent être déterminés avec un compte-tours magnétique selon la revendication 1 ou 2, dans lequel

- d'abord un schéma de domaines est empreint avec une seule paroi de domaine (111a) ou un écart défini des parois de domaine, l'écart entre au moins deux parois de domaine voisines (111, 112) étant supérieur à 360° relativement à leur déplacement de la première à la deuxième position lors de la rotation de l'élément rotatif (4) autour d'un angle supérieur à 360°, et
- selon ce schéma de parois de domaine empreint défini, toutes les valeurs de consigne des niveaux de signal à escompter des demi-ponts Wheatstone ou des pistes conductrices des parois de domaine sont enregistrées une fois sous forme de tableau dans une mémoire (10) dans la mémoire des valeurs de consigne (10) pour tous les tours complets possibles i de 360° ($0 \leq i \leq n$) et toutes les positions des parois de domaines changées associées qui peuvent être déterminés par un compte-tours magnétique, et
- les valeurs associées du capteur de tours (2) qui sont actuellement déterminées par les demi-ponts Wheatstone ou par les pistes conductrices des parois de domaine sont enregistrées dans un tableau (9a) d'une deuxième mémoire (9) pendant le comptage actuel, et
- ces valeurs mesurées (9a) sont comparées en continu avec les valeurs de consigne des niveaux de signal enregistrées dans la mémoire des valeurs de consigne (10) et
- sont délivrées en tant que nombre de tours i lors d'une coïncidence des valeurs des tableaux dans les deux mémoires (9, 10).

**9.** Procédé selon la revendication 8, dans lequel

- des valeurs de consigne des niveaux de signal sont enregistrées pour quatre quadrants d'angle de champ dans au moins quatre sous-tableaux (10a, 10b, 10c et 10d) de la mémoire des valeurs de consigne (10) pour chaque tour i individuel comptable par le compte-tours,
- la valeur mesurée (W8 (8a)) d'un capteur d'angle de rotation (3) ou d'un capteur à quadrants détermine le sous-tableau associé
- utilisé pour comparer en continu les valeurs mesurées (9a) par le capteur d'angle de rotation (2) afin de déterminer le nombre de tours associé.

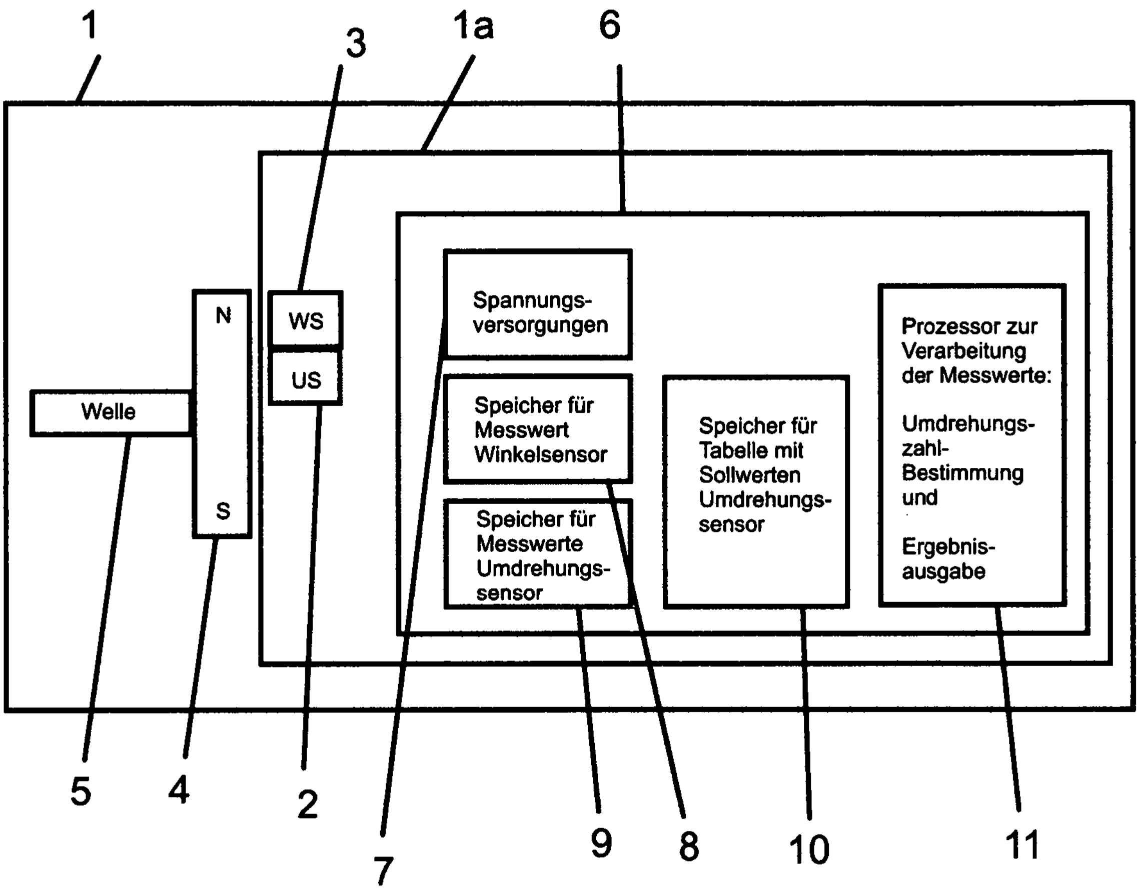
1
3
1a
6
N
WS
US
Spannungs-
versorgungen
Prozessor zur
Verarbeitung
der Messwerte:
Umdrehungs-
zahl-
Bestimmung
und
Ergebnis-
ausgabe
Welle
Speicher für
Messwert
Winkelsensor
Speicher für
Tabelle mit
Sollwerten
Umdrehungs-
sensor
S
Speicher für
Messwerte
Umdrehungs-
sensor
5
4
2
7
9
8
10
11

Fig. 1

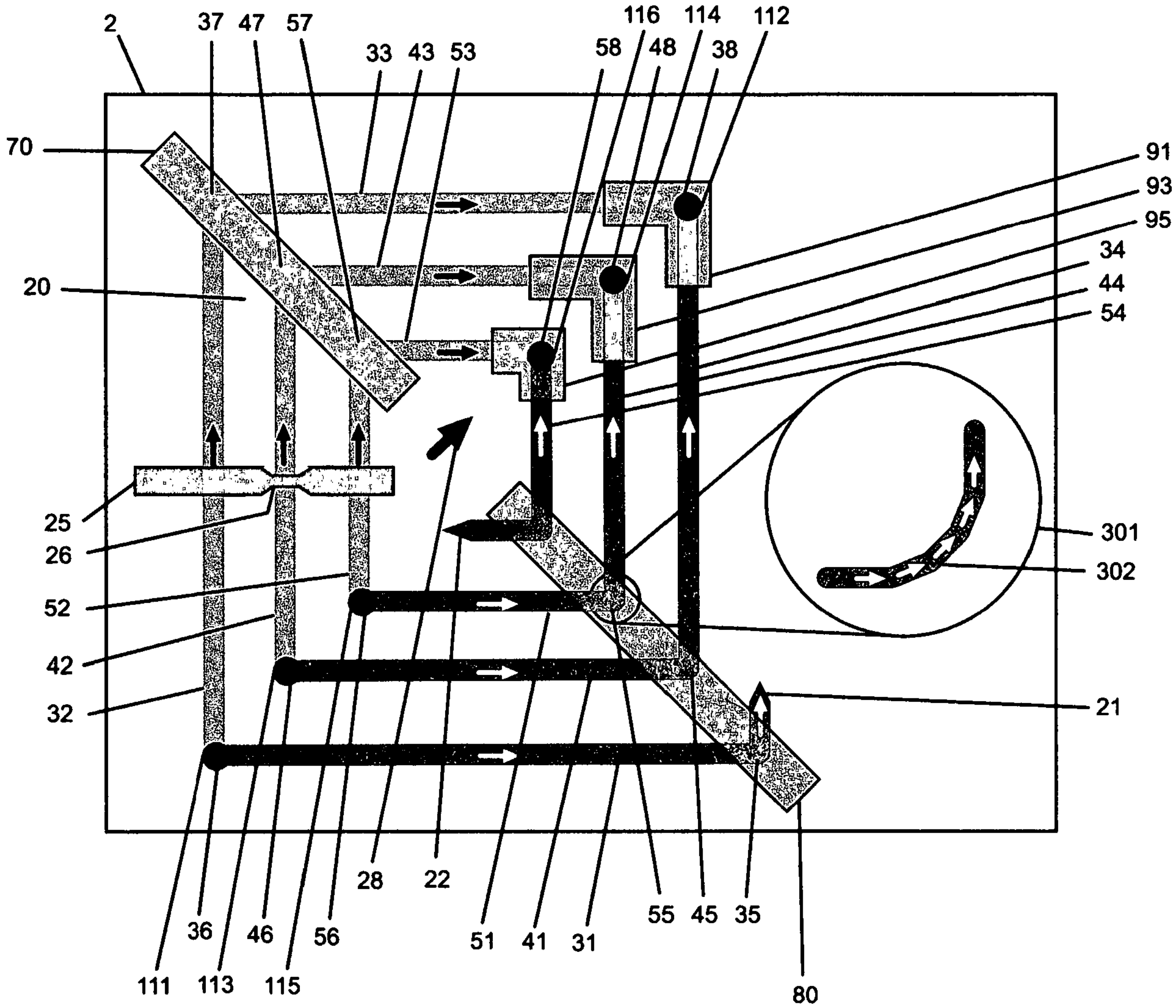
2
37
47
57
33
43
53
116
114
112
58
48
38
70
91
93
95
34
44
54
20
25
26
301
302
52
42
32
21
28
22
51
41
31
55
45
35
36
46
56
111
113
115
80

Fig. 2

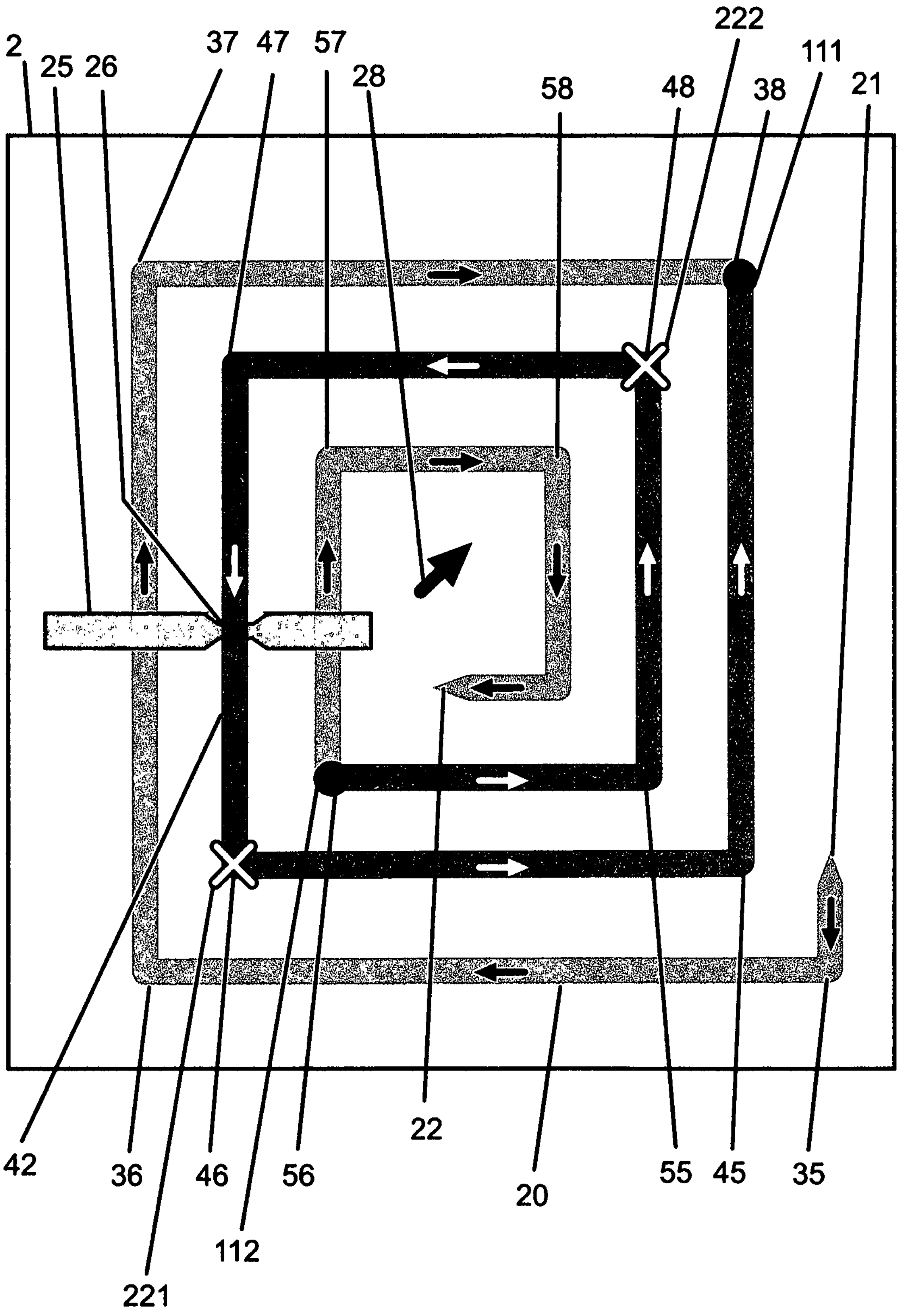
2
25
26
37
47
57
28
58
48
222
38
111
21
42
36
46
56
22
20
55
45
35
112
221

Fig. 3a

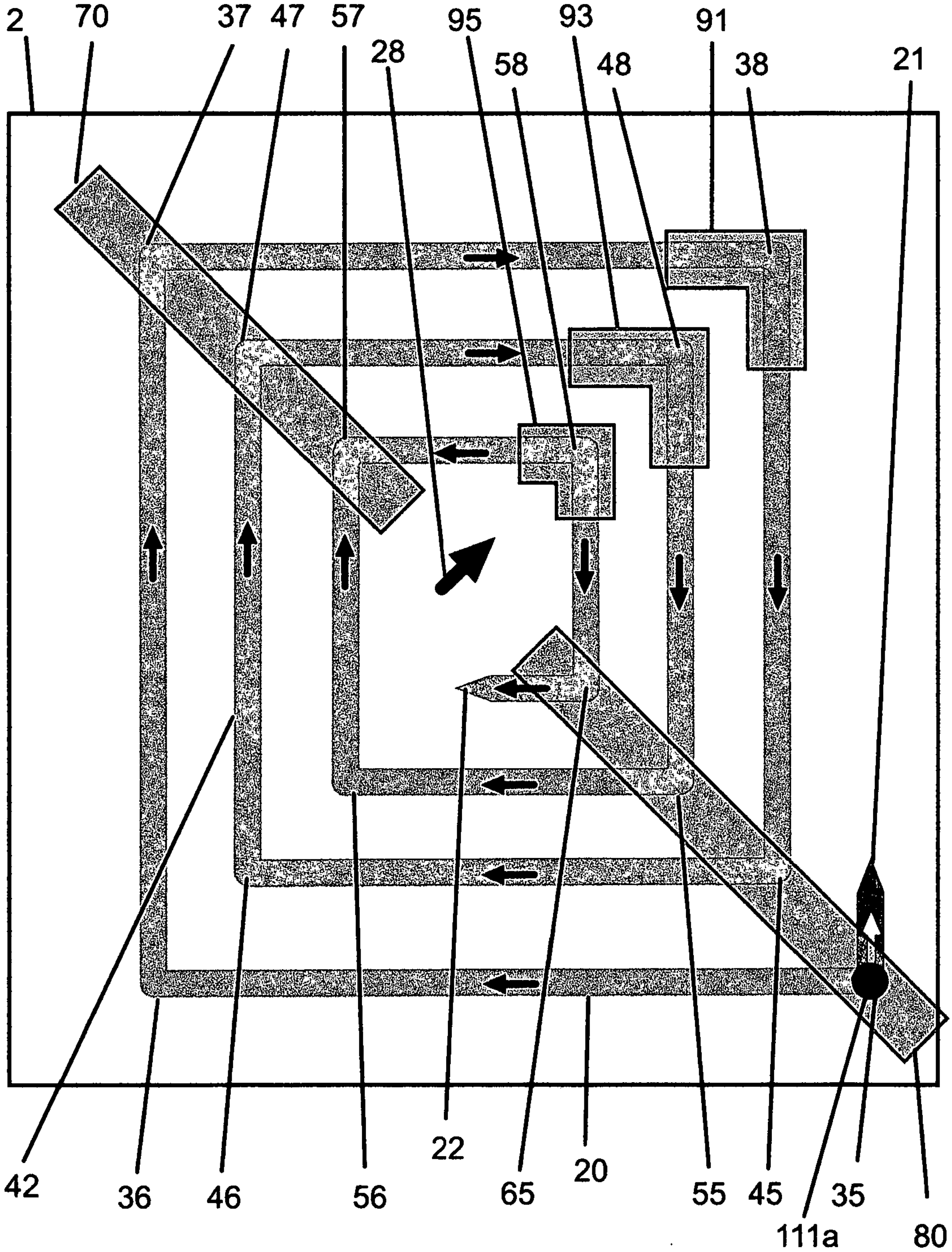
2
70
37
47
57
28
95
58
93
48
91
38
21
42
36
46
56
22
65
20
55
45
35
111a
80

Fig. 3b

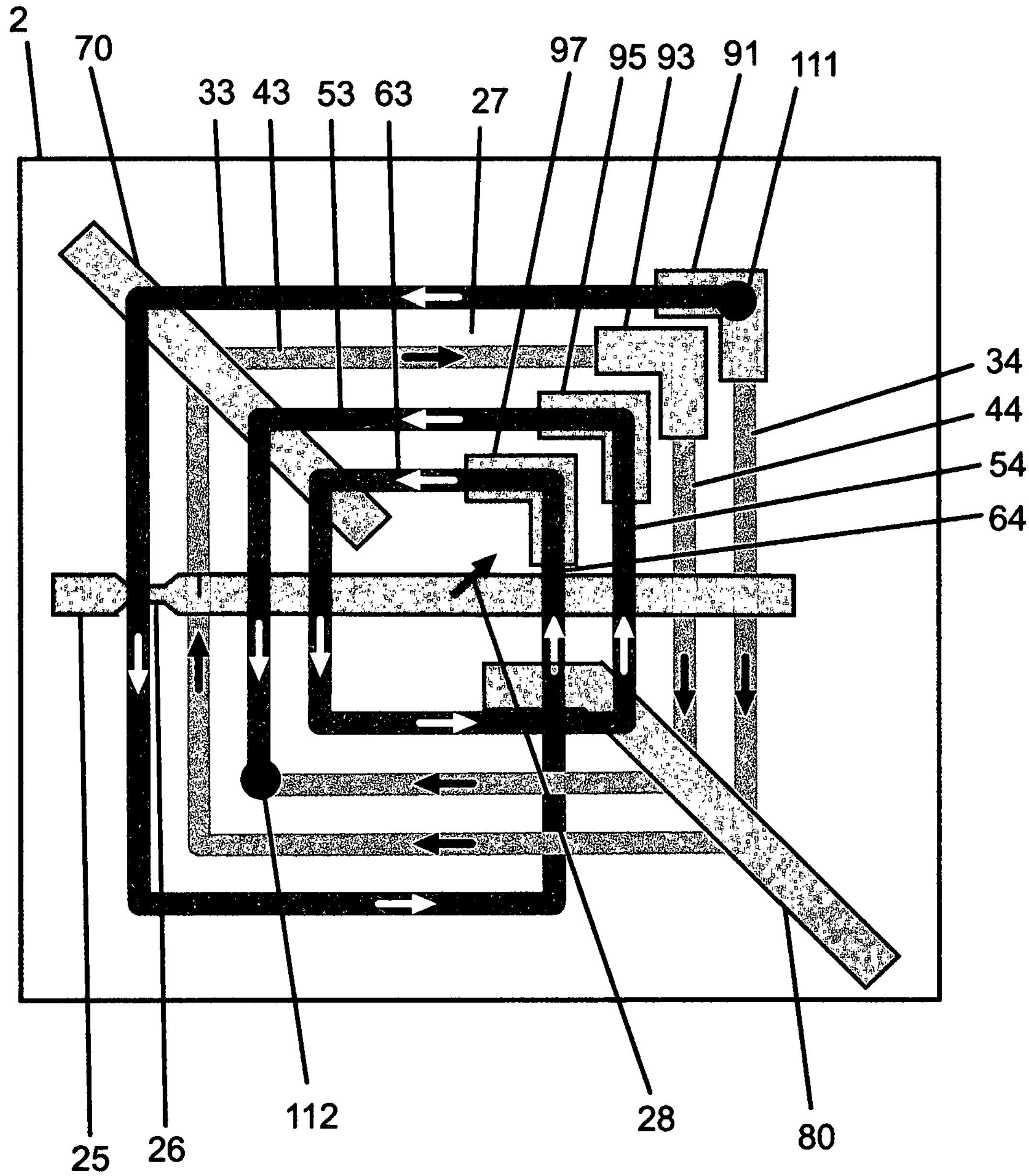


Fig. 4

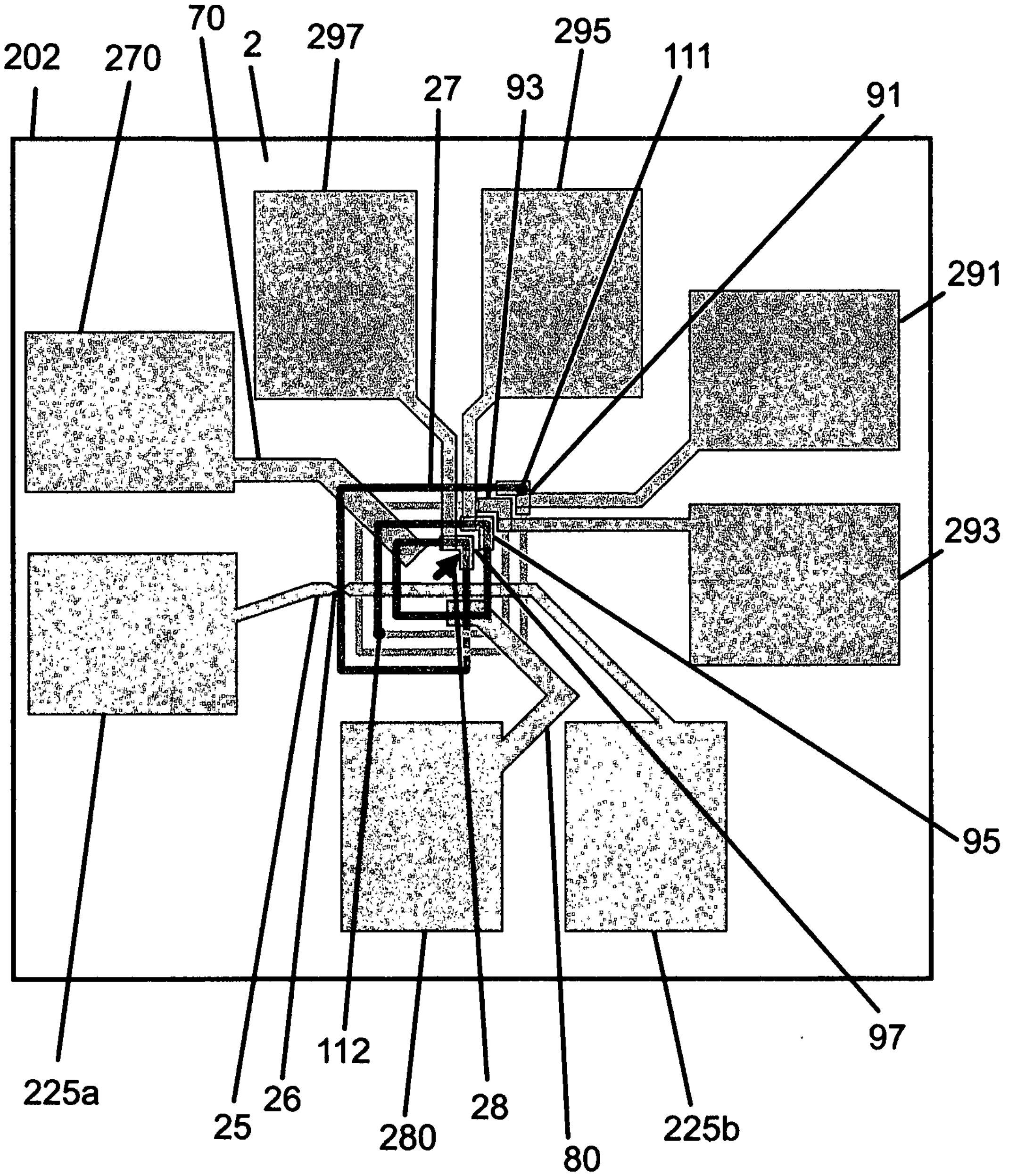
202
270
70
2
297
27
93
295
111
91
291
293
95
97
225a
25
26
112
280
28
80
225b

Fig. 5

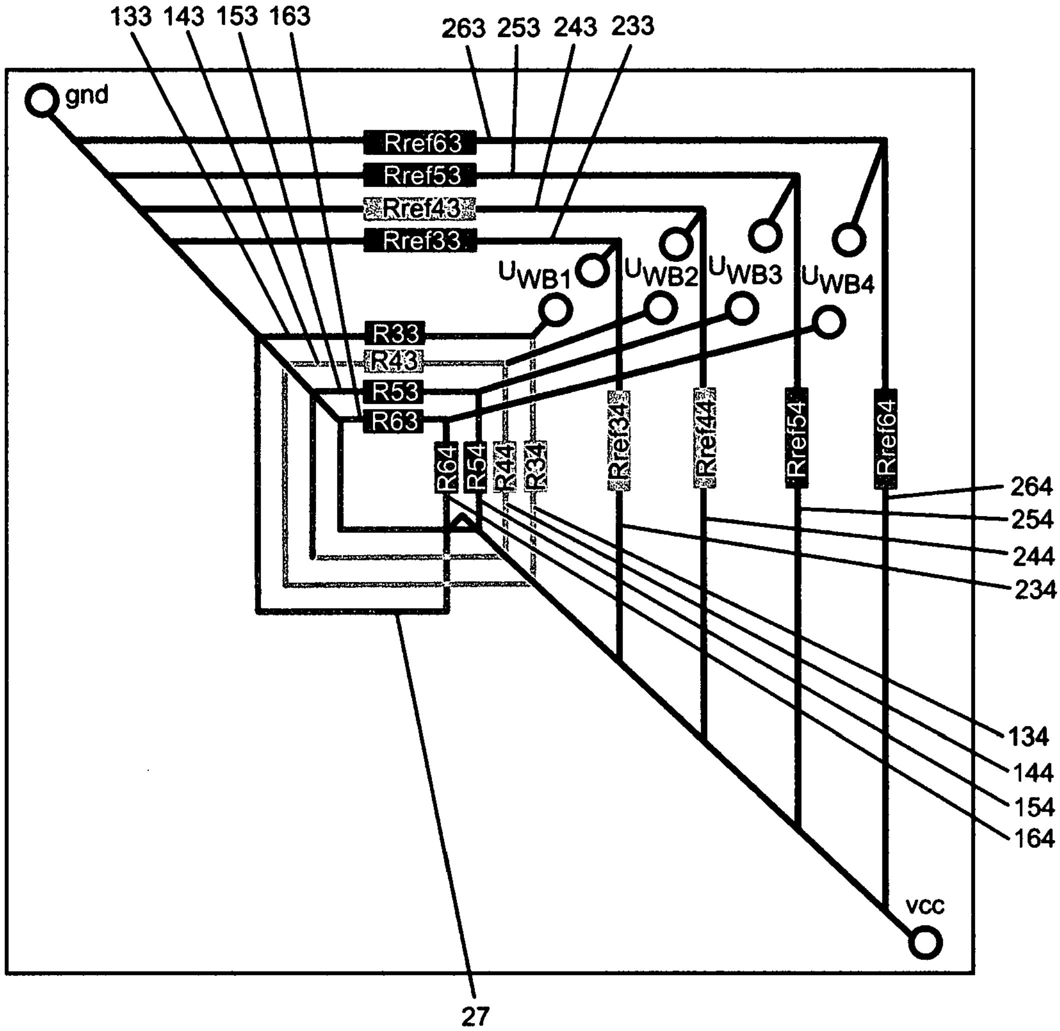
133 143 153 163
263 253 243 233
gnd
Rref63
Rref53
Rref43
Rref33
UWB1
UWB2
UWB3
UWB4
R33
R43
R53
R63
R64
R54
R44
R34
Rref34
Rref44
Rref54
Rref64
264
254
244
234
134
144
154
164
vcc
27

Fig. 6

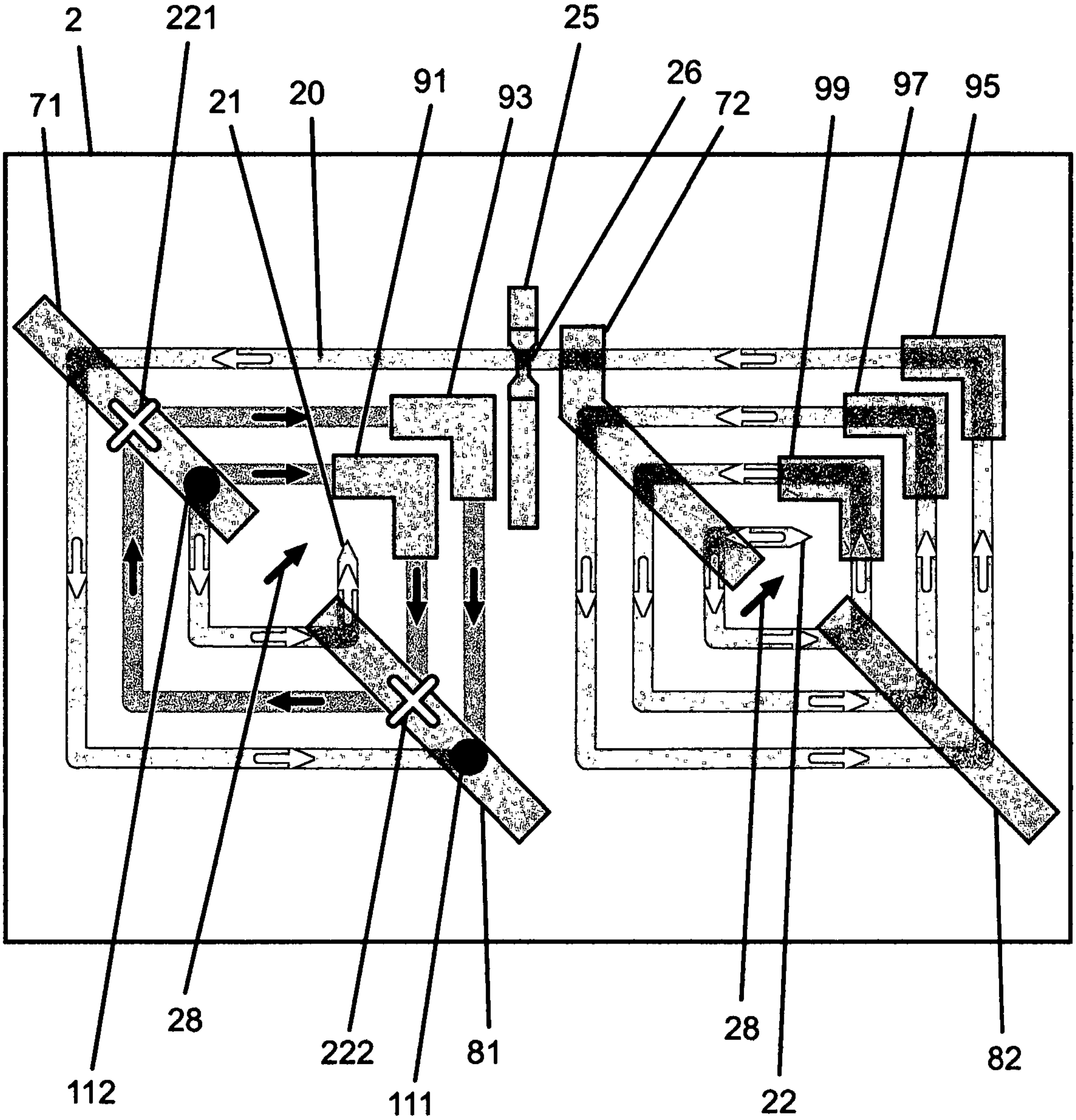


Fig. 7

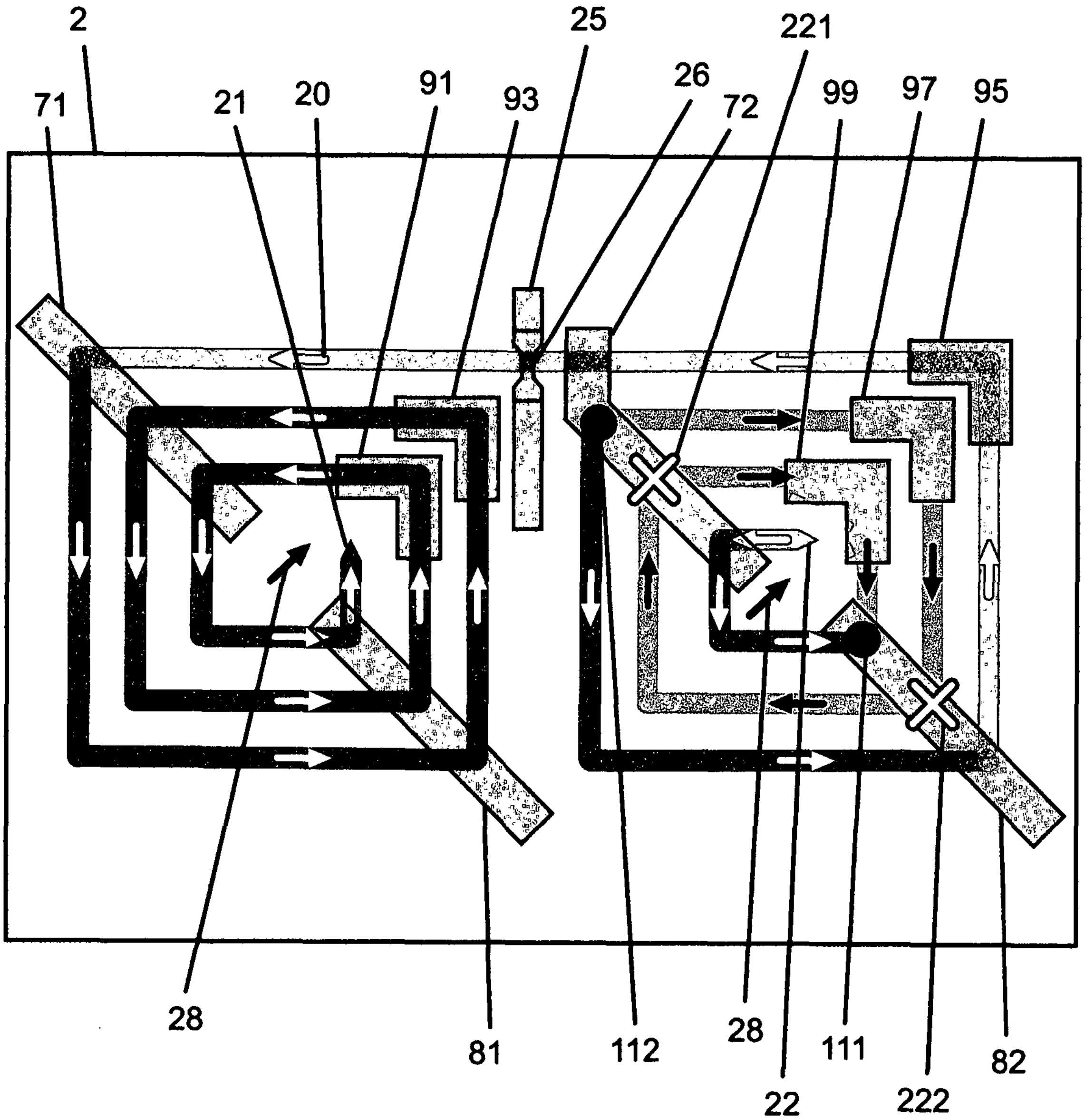


Fig. 8

| | Umdrehung | 0 | 1 | 2 | 3 |
|---|---|---|---|---|---|
| Windung | Feldwinkel-Quadrant | 1 | 1 | 1 | 1 |
| Halbbrücke | Mittelkontakt (unten) | | | | |
| W1 | 91 | L | H | H | H |
| W2 | 93 | L | L | H | H |
| W3 | 95 | H | L | L | H |
| W4 | 97 | H | H | L | L |
| W5 | 99 | H | H | H | L |

Figur 9a

| | Umdrehung | 0 | 1 | 2 | 3 |
|---|---|---|---|---|---|
| Windung | Feldwinkel-Quadrant | 2 | 2 | 2 | 2 |
| Halbbrücke | Mittelkontakt (unten) | | | | |
| W1 | 91 | M | H | H | H |
| W2 | 93 | L | M | H | H |
| W3 | 95 | H | L | M | H |
| W4 | 97 | H | H | L | M |
| W5 | 99 | H | H | H | L |

Figur 9b

| | Umdrehung | 0 | 1 | 2 | 3 |
|---|---|---|---|---|---|
| Windung | Feldwinkel-Quadrant | 3 | 3 | 3 | 3 |
| Halbbrücke | Mittelkontakt (unten) | | | | |
| W1 | 91 | H | H | H | H |
| W2 | 93 | L | H | H | H |
| W3 | 95 | H | L | H | H |
| W4 | 97 | H | H | L | H |
| W5 | 99 | H | H | H | L |

Figur 9c

| | Umdrehung | 0 | 1 | 2 | 3 |
|---|---|---|---|---|---|
| Windung | Feldwinkel-Quadrant | 4 | 4 | 4 | 4 |
| Halbbrücke | Mittelkontakt (unten) | | | | |
| W1 | 91 | H | H | H | H |
| W2 | 93 | L | H | H | H |
| W3 | 95 | M | L | H | H |
| W4 | 97 | H | M | L | H |
| W5 | 99 | H | H | M | L |

Figur 9d

**Fig. 9**

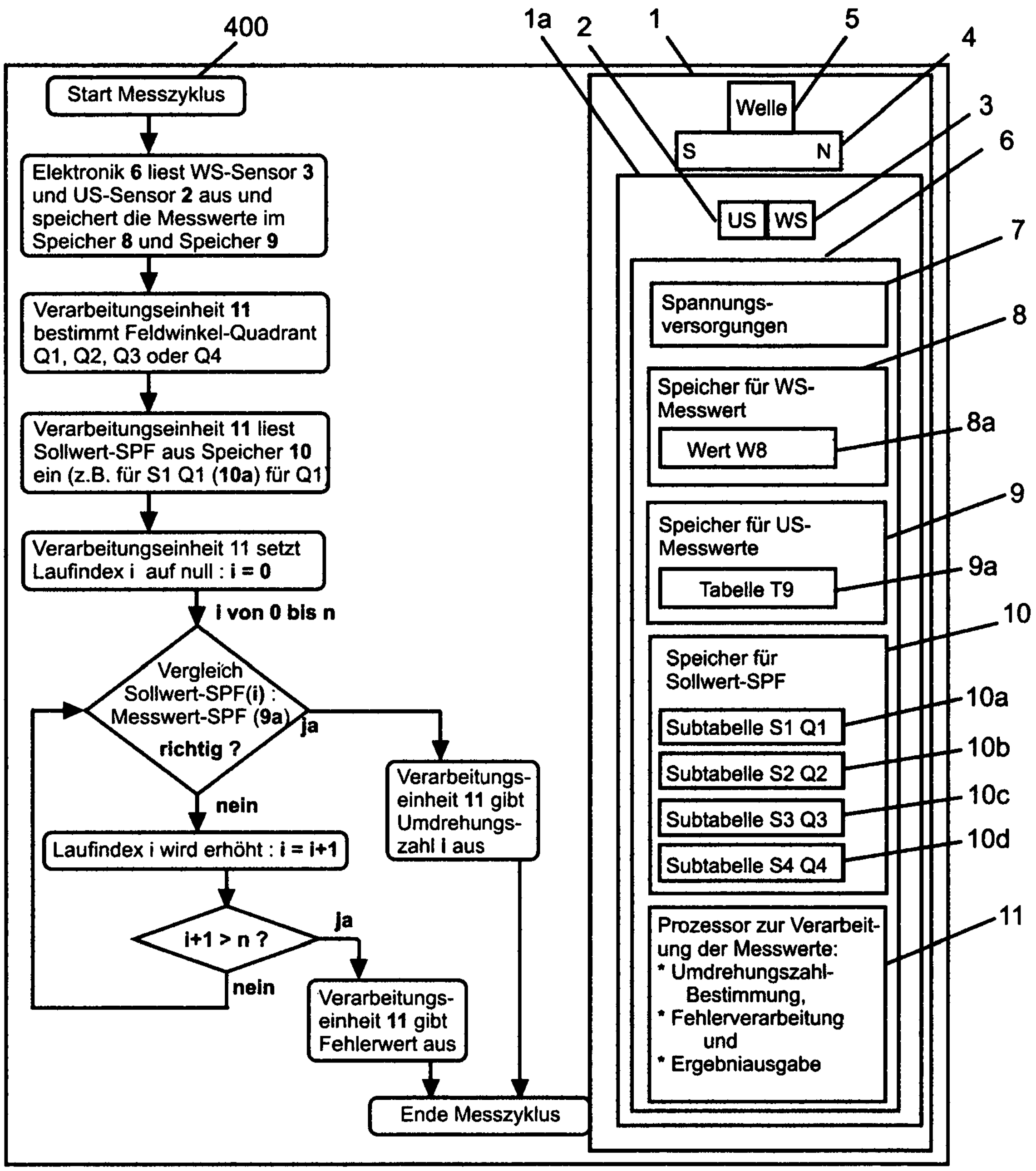
400
1a
2
1
5
4
3
6
7
8
8a
9
9a
10
10a
10b
10c
10d
11
Start Messzyklus
Elektronik 6 liest WS-Sensor 3 und US-Sensor 2 aus und speichert die Messwerte im Speicher 8 und Speicher 9
Verarbeitungseinheit 11 bestimmt Feldwinkel-Quadrant Q1, Q2, Q3 oder Q4
Verarbeitungseinheit 11 liest Sollwert-SPF aus Speicher 10 ein (z.B. für S1 Q1 (10a) für Q1
Verarbeitungseinheit 11 setzt Laufindex i auf null : i = 0
i von 0 bis n
Vergleich Sollwert-SPF(i) : Messwert-SPF (9a) richtig ?
ja
nein
Verarbeitungs-einheit 11 gibt Umdrehungs-zahl i aus
Laufindex i wird erhöht : i = i+1
i+1 > n ?
ja
nein
Verarbeitungs-einheit 11 gibt Fehlerwert aus
Ende Messzyklus
Welle
S
N
US
WS
Spannungs-versorgungen
Speicher für WS-Messwert
Wert W8
Speicher für US-Messwerte
Tabelle T9
Speicher für Sollwert-SPF
Subtabelle S1 Q1
Subtabelle S2 Q2
Subtabelle S3 Q3
Subtabelle S4 Q4
Prozessor zur Verarbeitung der Messwerte:
* Umdrehungszahl-Bestimmung,
* Fehlerverarbeitung und
* Ergebniausgabe

**Fig. 10**

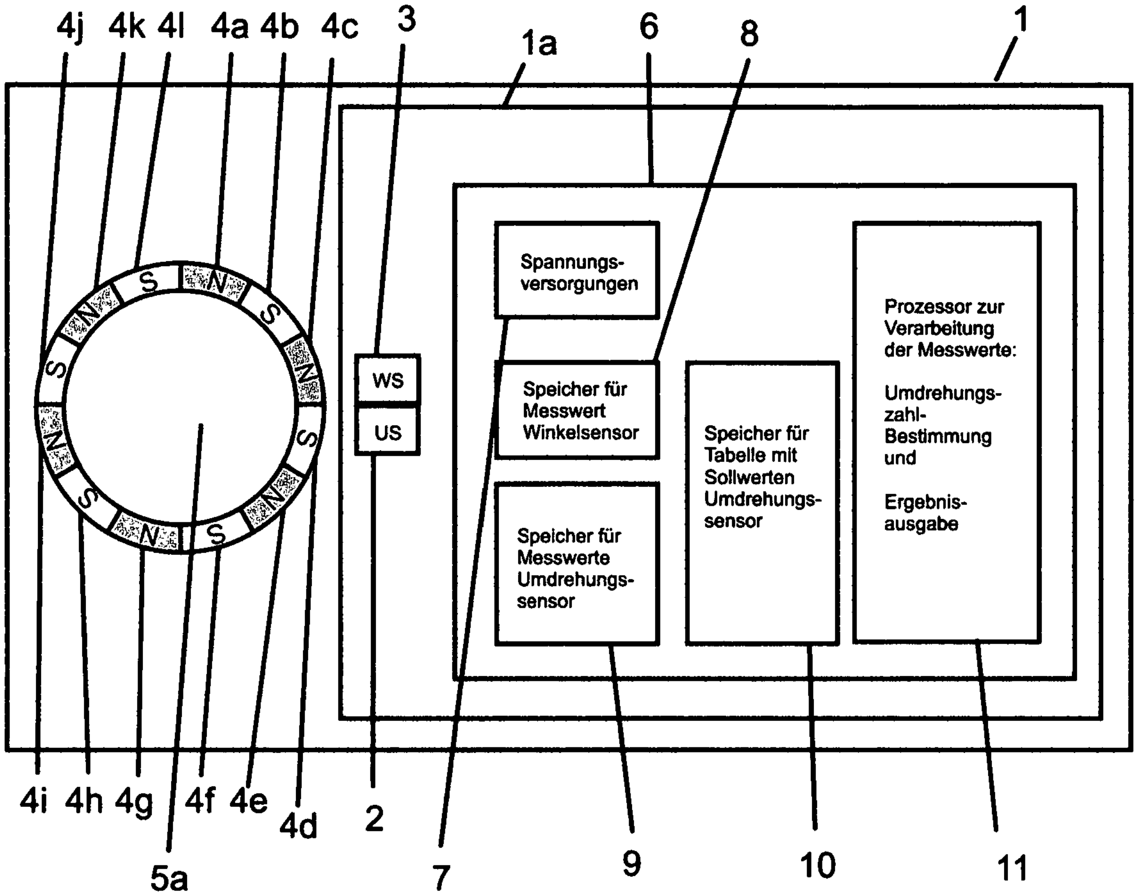
4j
4k
4l
4a
4b
4c
3
1a
6
8
1
S
N
S
N
S
N
S
N
S
N
S
N
WS
US
Spannungs-
versorgungen
Speicher für
Messwert
Winkelsensor
Speicher für
Messwerte
Umdrehungs-
sensor
Speicher für
Tabelle mit
Sollwerten
Umdrehungs-
sensor
Prozessor zur
Verarbeitung
der Messwerte:
Umdrehungs-
zahl-
Bestimmung
und
Ergebnis-
ausgabe
4i
4h
4g
4f
4e
4d
2
5a
7
9
10
11

Fig. 11

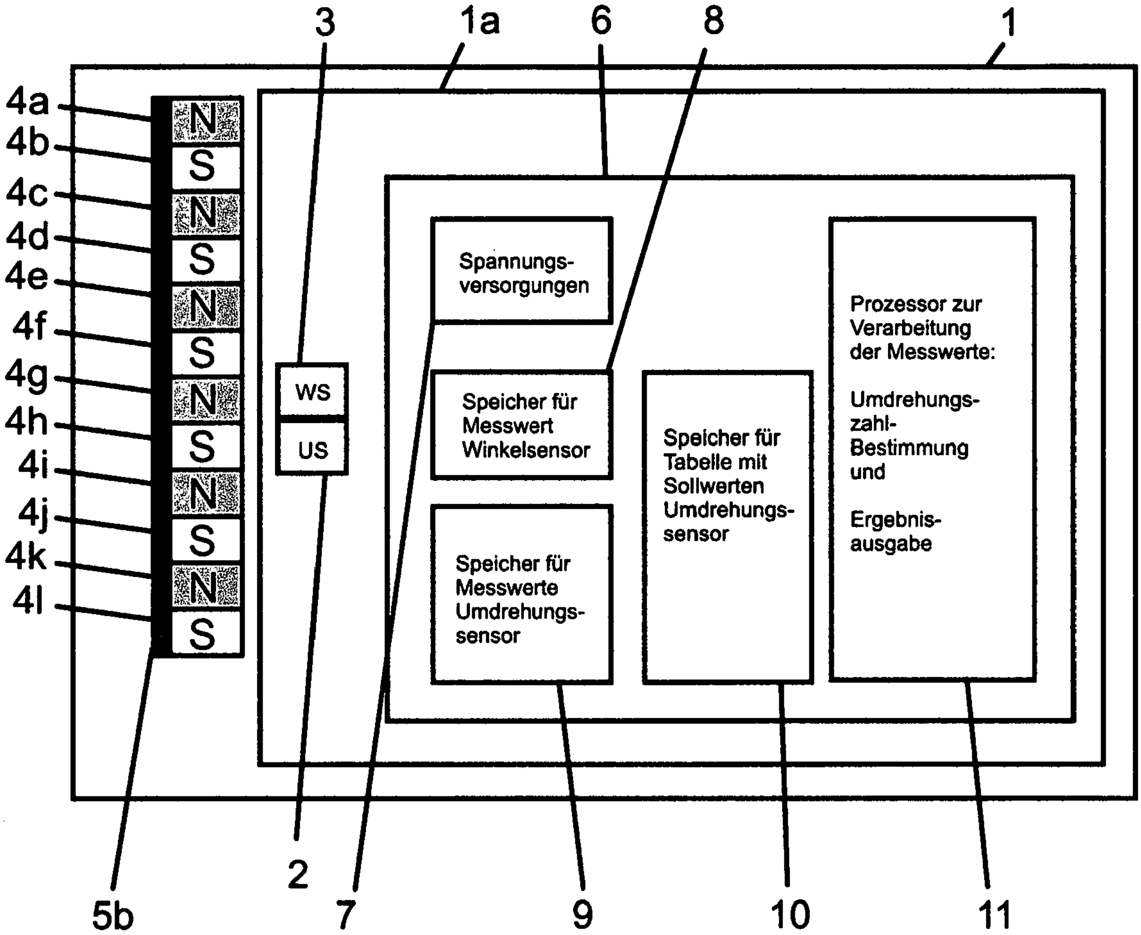
3
1a
6
8
1
4a
4b
4c
4d
4e
4f
4g
4h
4i
4j
4k
4l
N
S
N
S
N
S
N
S
N
S
N
S
WS
US
Spannungs-
versorgungen
Speicher für
Messwert
Winkelsensor
Speicher für
Messwerte
Umdrehungs-
sensor
Speicher für
Tabelle mit
Sollwerten
Umdrehungs-
sensor
Prozessor zur
Verarbeitung
der Messwerte:
Umdrehungs-
zahl-
Bestimmung
und
Ergebnis-
ausgabe
5b
2
7
9
10
11

**Fig. 12**

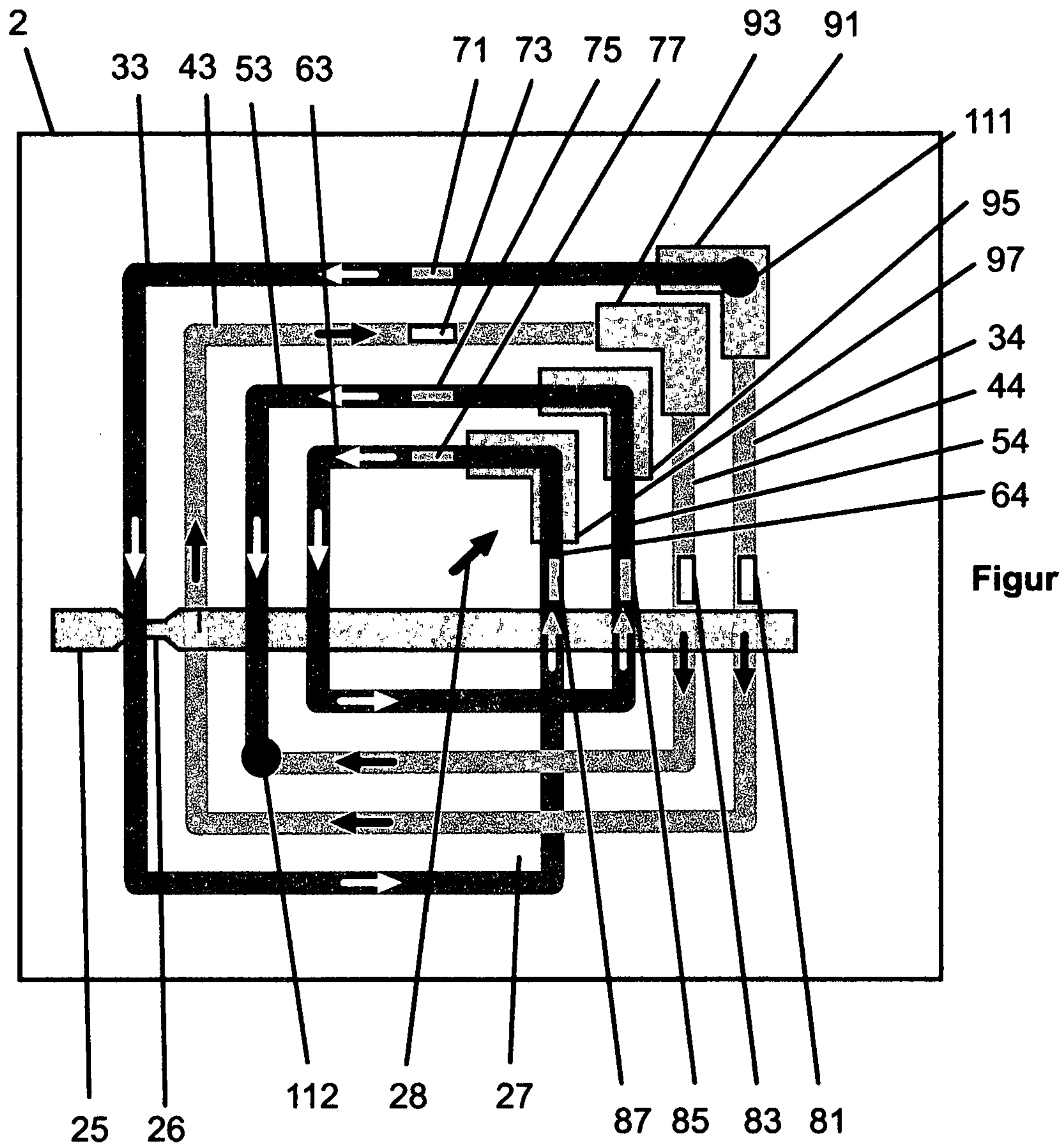


Figur 13a

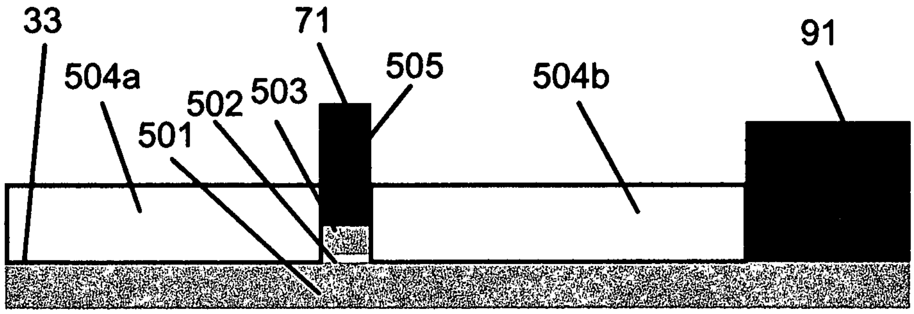


Figur 13b

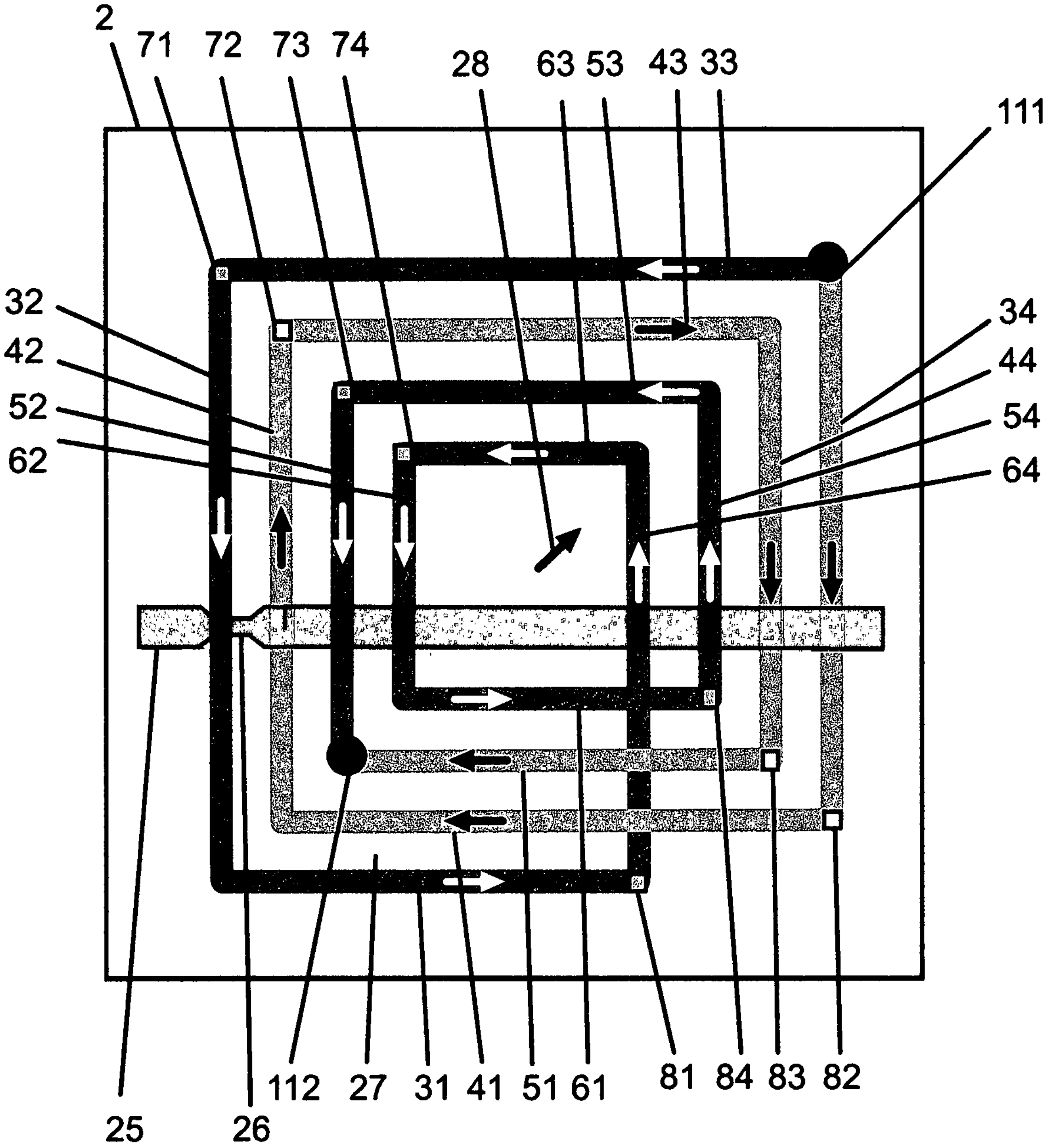
2
71
72
73
74
28
63
53
43
33
111
32
42
52
62
34
44
54
64
25
26
112
27
31
41
51
61
81
84
83
82

Fig. 14

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- DE 102008063226 A1
- DE 102010022611 A1
- DE 102011075306 A1
- DE 102013018680 A1
- DE 102010010893 A1
- DE 102010010893 B4

### In der Beschreibung aufgeführte Nicht-Patentliteratur

- *IEEE Transactions on Magnetics,* 2009, vol. 45 (10), 3792-3795